# EUROPEAN PATENT APPLICATION

(11) **EP 4 474 522 A1**
(43) Date of publication of application: **11.12.2024**
(21) Application number: 23747160.2
(22) Date of filing: 30.01.2023
(51) Int. Cl.: C23C 14/04, H05B 33/10, H10K 50/00

(54) **DEPOSITION MASK, DEPOSITION MASK WITH FRAME, METHOD FOR MANUFACTURING DEPOSITION MASK, METHOD FOR MANUFACTURING ORGANIC DEVICE, AND METHOD FOR MANUFACTURING DEPOSITION MASK WITH FRAME**

(30) Priority: 31.01.2022 JP 2022013696
(71) Applicant: Dai Nippon Printing Co., Ltd., Tokyo 162-8001 (JP)
(72) Inventor: IKENAGA, Chikao, Tokyo 162-8001 (JP)
(74) Representative: Müller-Boré & Partner Patentanwälte PartG mbB
(86) International application number: PCT/JP2023/002941
(87) International publication number: WO 2023/145950

(57) **Abstract**

A vapor deposition mask according to the present disclosure includes a mask substrate that contains silicon, a mask layer that includes a first surface and a second surface that is located opposite the first surface and that faces the mask substrate, and a through-hole that extends through the mask layer. The mask substrate includes a substrate opening. The through-hole is located in the substrate opening in a plan view. The mask layer includes a mask body layer that forms the first surface and a mask intermediate layer that is located between the mask body layer and the mask substrate. The mask body layer contains a resin material.

## Description

### TECHNICAL FIELD

The present disclosure relates to a vapor deposition mask, a framed vapor deposition mask, a method of manufacturing a vapor deposition mask, a method of manufacturing an organic device, and a method of manufacturing a framed vapor deposition mask.

### BACKGROUND ART

Display devices that are used by mobile devices such as smart phones or tablets are preferably high definition devices, and pixel density, for example, is preferably 400 ppi or more. The mobile devices are increasingly demanded so as to be compatible with ultra-high definition (UHD). In this case, for example, the pixel density of the display devices is preferably 800 ppi or more.

Attention is paid to an organic EL display device as an example of an organic device among the display devices because of good responsiveness, low power consumption, and high contrast. A method of forming pixels in a desired pattern by using a vapor deposition mask that includes through-holes that are arranged in a desired pattern is known as a method of forming the pixels of the organic EL display device. Specifically, the vapor deposition mask is first combined with a vapor deposition substrate for the organic EL display device. Subsequently, a vapor deposition material that contains an organic material is deposited on the vapor deposition substrate via the through-holes of the vapor deposition mask. Consequently, a vapor deposition layer (or a light-emitting layer of the organic EL display device) that contains the vapor deposition material can be formed as the pixels on the vapor deposition substrate in the same pattern as that of the through-holes of the vapor deposition mask (see, for example, PTL 1 to PTL 3).

A method of forming through-holes in a plate material by performing an etching process in which a photolithography technique is used is known as an example of a method of manufacturing the vapor deposition mask.
PTL 1: Japanese Patent No. 5382259
PTL 2: Korean patent 10-1812772
PTL 3: Japanese Unexamined Patent Application Publication No. 2010-116579

### SUMMARY

It is an object of the present disclosure to provide a vapor deposition mask, a framed vapor deposition mask, a method of manufacturing a vapor deposition mask, a method of manufacturing an organic device, and a method of manufacturing a framed vapor deposition mask that can improve definition.

A vapor deposition mask according to the present disclosure includes a mask substrate that contains silicon, a mask layer that includes a first surface and a second surface that is located opposite the first surface and that faces the mask substrate, a through-hole that extends through the mask layer. The mask substrate includes a substrate opening. The through-hole is located in the substrate opening in a plan view. The mask layer includes a mask body layer that forms the first surface and a mask intermediate layer that is located between the mask body layer and the mask substrate. The mask body layer contains a resin material.

A framed vapor deposition mask according to the present disclosure includes the vapor deposition mask described above and a frame that supports the mask substrate of the vapor deposition mask.

A method of manufacturing a vapor deposition mask according to the present disclosure includes a substrate preparation step of preparing a mask substrate that contains silicon, a mask layer formation step, a substrate opening formation step, and a through-hole formation step. At the mask layer formation step, a mask layer that includes a first surface and a second surface that is located opposite the first surface and that faces the mask substrate on the mask substrate is formed. At the substrate opening formation step, a substrate opening in the mask substrate is formed. At the through-hole formation step, a through-hole that extends through the mask layer is formed. The through-hole is located in the substrate opening in a plan view. The mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate. The mask body layer contains a resin material.

A method of manufacturing an organic EL device according to the present disclosure includes a vapor deposition mask preparation step of preparing the vapor deposition mask by using the method of manufacturing the vapor deposition mask described above, a close contact step, and a vapor deposition step. At the close contact step, the first surface of a mask layer of the vapor deposition mask is caused to come into close contact with a vapor deposition substrate. At the vapor deposition step, a vapor deposition layer is formed in a manner in which a vapor deposition material is deposited on the vapor deposition substrate via the through-hole of the vapor deposition mask.

A method of manufacturing a framed vapor deposition mask according to the present disclosure includes a vapor deposition mask preparation step of preparing the vapor deposition mask by using the method of manufacturing the vapor deposition mask described above, and a frame attachment step of attaching a frame to the mask substrate of the vapor deposition mask.

According to the present disclosure, definition can be improved.

### BRIEF DESCRIPTION OF DRAWINGS

Fig. 1 illustrates a vapor deposition apparatus that includes a vapor deposition mask according to an embodiment of the present disclosure.
Fig. 2 illustrates a plan view of the vapor deposition mask according to the embodiment of the present disclosure.
Fig. 3 schematically illustrates a section taken along a line A-A in Fig. 2.
Fig. 4 illustrates an enlarged plan view of a portion of the vapor deposition mask in Fig. 2.
Fig. 5A illustrates an enlarged plan view of a portion of a through-hole group of the vapor deposition mask in Fig. 4.
Fig. 5B illustrates an enlarged plan view of a portion of a modification to the through-hole group in Fig. 5A.
Fig. 6 illustrates a substrate preparation step in a method of manufacturing the vapor deposition mask according to the embodiment of the present disclosure.
Fig. 7 illustrates a mask intermediate layer formation step in the method of manufacturing the vapor deposition mask according to the embodiment of the present disclosure.
Fig. 8 illustrates a resin layer formation step in the method of manufacturing the vapor deposition mask according to the embodiment of the present disclosure.
Fig. 9 illustrates a mask protection layer formation step in the method of manufacturing the vapor deposition mask according to the embodiment of the present disclosure.
Fig. 10 illustrates a resist layer formation step at a substrate opening formation step in the method of manufacturing the vapor deposition mask according to the embodiment of the present disclosure.
Fig. 11 illustrates a substrate etching step at the substrate opening formation step in the method of manufacturing the vapor deposition mask according to the embodiment of the present disclosure.
Fig. 12A illustrates a step of forming a first recessed portion at the substrate etching step in Fig. 11.
Fig. 12B illustrates a step of forming a first protection layer at the substrate etching step in Fig. 11.
Fig. 12C illustrates a step of forming a second recessed portion at the substrate etching step in Fig. 11.
Fig. 12D illustrates a step of forming a second protection layer at the substrate etching step in Fig. 11.
Fig. 12E illustrates a step of forming a fourth recessed portion at the substrate etching step in Fig. 11.
Fig. 13 illustrates a resist layer removal step at the substrate opening formation step in the method of manufacturing the vapor deposition mask according to the embodiment of the present disclosure.
Fig. 14 illustrates a mask layer opening formation step and a mask protection layer removal step in the method of manufacturing the vapor deposition mask according to the embodiment of the present disclosure.
Fig. 15A illustrates a through-hole formation step at which a resin layer is irradiated with laser light in the method of manufacturing the vapor deposition mask according to the embodiment of the present disclosure.
Fig. 15B illustrates a modification to Fig. 15A.
Fig. 15C schematically illustrates a laser light generation device in Fig. 15B.
Fig. 16 illustrates the through-hole formation step at which the through-hole is formed in the method of manufacturing the vapor deposition mask according to the embodiment of the present disclosure.
Fig. 17A illustrates a plan view of an example of an organic EL display device that is manufactured by using the vapor deposition mask according to the embodiment of the present disclosure and illustrates an organic layer that is deposited at a vapor deposition step.
Fig. 17B illustrates a sectional view of the organic EL display device in Fig. 17A viewed in a B-B direction.
Fig. 18 schematically illustrates a section of a modification to the vapor deposition mask illustrated in Fig. 3.
Fig. 19 illustrates a plan view of a modification to the vapor deposition mask illustrated in Fig. 2.
Fig. 20 illustrates an enlarged plan view of a portion of a modification to the vapor deposition mask illustrated in Fig. 4.
Fig. 21 illustrates a plan view of a modification to the vapor deposition mask illustrated in Fig. 2.
Fig. 22 schematically illustrates a section taken along a line C-C in Fig. 21.
Fig. 23 illustrates a plan view of a modification to the vapor deposition mask illustrated in Fig. 21.
Fig. 24 illustrates a plan view of a modification to the vapor deposition mask illustrated in Fig. 21.
Fig. 25 illustrates an enlarged plan view of a modification to the substrate opening of the vapor deposition mask according to the embodiment of the present disclosure.
Fig. 26 illustrates an enlarged plan view of another modification to the substrate opening of the vapor deposition mask according to the embodiment of the present disclosure.
Fig. 27 illustrates an enlarged plan view of another modification to the substrate opening of the vapor deposition mask according to the embodiment of the present disclosure.
Fig. 28 illustrates a plan view of a modification to the vapor deposition mask illustrated in Fig. 21.
Fig. 29 schematically illustrates a section taken along a line D-D in Fig. 28.
Fig. 30 schematically illustrates a section of another modification to the vapor deposition mask illustrated in Fig. 3.
Fig. 31 illustrates a plan view of another modification to the vapor deposition mask illustrated in Fig. 21.
Fig. 32 schematically illustrates a section taken along a line E-E in Fig. 31.

### DESCRIPTION OF EMBODIMENTS

In the present specification and the drawings, words that mean substances on which components such as a "substrate", a "base material", a "plate", a "sheet", and a "film" are based are not distinguished from each other only based on different names unless there is a particular description.

In the present specification and the drawings, words such as "parallel" and "perpendicular" and the values of a length and an angle that specify shapes, geometrical conditions, and the degree of these, for example, are not limited by strict meaning but are interpreted to an extent that the same function can be expected unless there is a particular description.

In some cases where a component such as a member or a region is "on" or "under", "on an upper side of" or "on a lower side of", or "above" or "below" another component such as another member or another region in the present specification and the drawings, the cases include a case where the component is in direct contact with the other component unless there is a particular description. The cases also include a case where another component is between the component and the other component, that is, a case where the component and the other component are indirectly connected to each other. As for the words "on", "upper side", and "above", or "under", "lower side", and "below", an up-down direction may be reversed unless there is a particular description.

A state in which a surface of an element A "faces" a surface of an element B includes not only the case where the surface of the element A is in contact with the surface of the element B but also the case where an element C is located between the surface of the element A and the surface of the element B in the present specification and the drawings unless there is a particular description. That is, the term "face" represents the directions of two surfaces.

In the present specification and the drawings, like portions or portions that have the same function are designated by like reference characters or similar reference characters unless there is a particular description, and a duplicated description for these is omitted in some cases. For convenience of description, the ratio of dimensions in the drawings differs from an actual ratio, and an illustration of a portion of a component is omitted in the drawings in some cases.

In the present specification and the drawings, a combination with another embodiment or a modification can be used without contradiction unless there is a particular description. Other embodiments can be combined with each other, and another embodiment and a modification can be combined with each other without contradiction. Modifications can be combined with each other without contradiction.

In the case where multiple steps related to a method such as a manufacturing method are disclosed in the present specification and the drawings, another step that is not disclosed may be performed between the disclosed steps unless there is a particular description. The order of the disclosed steps is freely determined without contradiction.

In the present specification and the drawings, a numerical range that is represented by the character "to" includes numerals placed in front of and behind the character "to" unless there is a particular description. For example, the numerical range that is defined as the expression "34 mass% to 38 mass%" is the same as the numerical range that is defined as the expression "34 mass% or more and 38 mass% or less".

According to an embodiment in the present specification, a vapor deposition mask that is used for patterning an organic material on a substrate in a desired pattern when an organic device is manufactured and a method of manufacturing the vapor deposition mask will be described by way of example in the present specification and the drawings unless there is a particular description. However, the present embodiment is not limited to such use but can be used for vapor deposition masks that are used in various ways.

An embodiment of the present disclosure will now be described in detail with reference to the drawings. The embodiment described below is an example of an embodiment of the present disclosure, and the present disclosure is not interpreted so as to be limited only to the embodiment.

According to a first aspect of the present disclosure, a vapor deposition mask includes a mask substrate that contains silicon, a mask layer that includes a first surface and a second surface that is located opposite the first surface and that faces the mask substrate, and a through-hole that extends through the mask layer, the mask substrate includes a substrate opening, the through-hole is located in the substrate opening in a plan view, the mask layer includes a mask body layer that forms the first surface and a mask intermediate layer that is located between the mask body layer and the mask substrate, and the mask body layer contains a resin material.

According to a second aspect of the present disclosure, a thickness of the mask intermediate layer may be less than a thickness of the mask body layer, as for the vapor deposition mask according to the first aspect described above.

According to a third aspect of the present disclosure, the mask intermediate layer may contain gold, aluminum, chromium, nickel, titanium, titanium nitride, an aluminum alloy that contains neodymium, a silicon oxide, or a silicon dioxide, and the mask intermediate layer may be in contact with the mask body layer and may be in contact with the mask substrate, as for the vapor deposition mask according to the first aspect described above or the second aspect described above.

According to a fourth aspect of the present disclosure, the resin material of the mask body layer may contain polyimide, as for the vapor deposition mask according to any one of the first aspect described above to the third aspect described above.

According to a fifth aspect of the present disclosure, the mask substrate may include a substrate body that defines the substrate opening, the mask intermediate layer may include a body region portion that is located between the mask body layer and the substrate body and a mask layer opening that is formed along the substrate opening in a plan view, and the through-hole may extend through the mask body layer, as for the vapor deposition mask according to any one of the first aspect described above to the fourth aspect described above.

According to a sixth aspect of the present disclosure, an opening dimension of the through-hole in a predetermined direction at a surface of the mask body layer facing the mask substrate may be larger than an opening dimension of the through-hole in the predetermined direction at the first surface, as for the vapor deposition mask according to the fifth aspect described above.

According to a seventh aspect of the present disclosure, the mask substrate may include a substrate body that defines the substrate opening, the mask intermediate layer may include a body region portion that is located between the mask body layer and the substrate body and an opening region portion that is located in the substrate opening in a plan view, and the through-hole may extend through the mask body layer and the opening region portion, as for the vapor deposition mask according to any one of the first aspect described above to the fourth aspect described above.

According to an eighth aspect of the present disclosure, an opening dimension of the through-hole in a predetermined direction at the second surface may be larger than an opening dimension of the through-hole in the predetermined direction at the first surface, as for the vapor deposition mask according to the seventh aspect described above.

According to a ninth aspect of the present disclosure, the mask layer may include two or more of the through-holes, and the two or more of the through-holes may be located in the substrate opening in a plan view, as for the vapor deposition mask according to any one of the first aspect described above to the eighth aspect described above.

According to a tenth aspect of the present disclosure, the mask layer may include two or more through-hole groups that are formed by the two or more of the through-holes, and the two or more through-hole groups may be located in the substrate opening in a plan view, as for the vapor deposition mask according to the ninth aspect described above.
according to an eleventh aspect of the present disclosure, the mask substrate may include two or more of the substrate openings, the mask layer may include two or more through-hole groups that are formed by the two or more of the through-holes, and the two or more through-hole groups may be located in the substrate openings in a plan view, as for the vapor deposition mask according to the ninth aspect described above.

According to a twelfth aspect of the present disclosure, the mask substrate may include two or more of the substrate openings, the mask layer may include two or more through-hole groups that are formed by the two or more of the through-holes, and a corresponding one of the through-hole groups may be located in each substrate opening in a plan view, as for the vapor deposition mask according to the ninth aspect described above.

According to a thirteenth aspect of the present disclosure, the substrate opening may have a rectangular shape in a plan view, and curved portions may be provided at four corners of a contour of the substrate opening in a plan view, as for the vapor deposition mask according to any one of the first aspect described above to the twelfth aspect described above.

According to a fourteenth aspect of the present disclosure, a first alignment mark may be provided on a surface of the mask substrate opposite the mask layer, as for the vapor deposition mask according to any one of the first aspect described above to the fourth aspect described above.

According to a fifteenth aspect of the present disclosure, the mask substrate may include a substrate body that defines the substrate opening and an inner projecting portion that projects inward from the substrate body in a plan view, and the first alignment mark may be located on the inner projecting portion, as for the vapor deposition mask according to the fourteenth aspect described above.

According to a sixteenth aspect of the present disclosure, a second alignment mark may be provided at a position nearer than the first alignment mark to the through-hole, as for the vapor deposition mask according to the fourteenth aspect described above or the fifteenth aspect described above.

According to a seventeenth aspect of the present disclosure, the mask layer may include two or more of the through-holes, two or more through-hole groups that are formed by the two or more of the through-holes and a mask sash bar that is provided between the through-hole groups adjacent to each other, and the second alignment mark may be located on the mask sash bar, as for the vapor deposition mask according to the sixteenth aspect described above.

According to an eighteenth aspect of the present disclosure, the mask sash bar may include a first mask sash bar and a second mask sash bar that extend in respective directions perpendicular to each other in a plan view, and the second alignment mark may be located at an intersecting portion at which the first mask sash bar and the second mask sash bar intersect with each other, as for the vapor deposition mask according to the seventeenth aspect described above.

According to a nineteenth aspect of the present disclosure, an outer edge of the mask body layer may be located inside an outer edge of the mask intermediate layer in a plan view, as for the vapor deposition mask according to any one of the first aspect described above to the eighteenth aspect described above.

According to a twentieth aspect of the present disclosure, the mask body layer may include two or more body islands, and a groove that extends through the mask body layer may be located between two of the body islands adjacent to each other, as for the vapor deposition mask according to any one of the first aspect described above to the nineteenth aspect described above.

According to a twenty-first aspect of the present disclosure, a framed vapor deposition mask includes the vapor deposition mask according to any one of the first aspect described above to the twentieth aspect described above, and a frame that supports the mask substrate of the vapor deposition mask.

According to a twenty-second aspect of the present disclosure, a method of manufacturing a vapor deposition mask includes a substrate preparation step of preparing a mask substrate that contains silicon, a mask layer formation step of forming a mask layer that includes a first surface and a second surface that is located opposite the first surface and that faces the mask substrate on the mask substrate, a substrate opening formation step of forming a substrate opening in the mask substrate, and a through-hole formation step of forming a through-hole that extends through the mask layer. The through-hole is located in the substrate opening in a plan view. The mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate. The mask body layer contains a resin material.

According to a twenty-third aspect of the present disclosure, at the through-hole formation step, the through-hole may be formed by irradiating the mask layer with laser light, as for the method of manufacturing the vapor deposition mask according to the twenty-second aspect described above.

According to a twenty-fourth aspect of the present disclosure, the through-hole formation step may be performed after the substrate opening formation step, and the mask layer may be irradiated with the laser light via the substrate opening, as for the method of manufacturing the vapor deposition mask according to the twenty-third aspect described above.

According to a twenty-fifth aspect of the present disclosure, at the through-hole formation step, the mask layer may be irradiated with the laser light via a mask hole that corresponds to the through-hole of a photo mask, as for the method of manufacturing the vapor deposition mask according to the twenty-third aspect described above or the twenty-fourth aspect described above.

According to a twenty-sixth aspect of the present disclosure, the photo mask may include a plurality of the mask holes, and at the through-hole formation step, the mask layer may be irradiated with the laser light via the plurality of the mask holes of the photo mask, as for the method of manufacturing the vapor deposition mask according to the twenty-fifth aspect described above.

According to a twenty-seventh aspect of the present disclosure, a mask layer opening formation step of forming a mask layer opening in the mask intermediate layer along the substrate opening in a plan view after the substrate opening formation step may be further included, and at the through-hole formation step, the through-hole may be formed so as to extend through the mask body layer, as for the method of manufacturing the vapor deposition mask according to any one of the twenty-second aspect described above to the twenty-sixth aspect described above.

According to a twenty-eighth aspect of the present disclosure, an opening dimension of the through-hole in a predetermined direction at a surface of the mask body layer facing the mask substrate may be larger than an opening dimension of the through-hole in the predetermined direction at the first surface, as for the method of manufacturing the vapor deposition mask according to the twenty-seventh aspect described above.

According to a twenty-ninth aspect of the present disclosure, the mask substrate may include a substrate body that defines the substrate opening, the mask intermediate layer may include a body region portion that is located between the mask body layer and the substrate body and an opening region portion that is located in the substrate opening in a plan view, and at the through-hole formation step, the through-hole may be formed so as to extend through the mask body layer and the opening region portion, as for the method of manufacturing the vapor deposition mask according to any one of the twenty-second aspect described above to the twenty-sixth aspect described above.

According to a thirtieth aspect of the present disclosure, an opening dimension of the through-hole in a predetermined direction at the second surface may be larger than an opening dimension of the through-hole in the predetermined direction at the first surface, as for the method of manufacturing the vapor deposition mask according to the twenty-ninth aspect described above.
according to a thirty-first aspect of the present disclosure, the resin material of the mask body layer may contain polyimide, as for the method of manufacturing the vapor deposition mask according to any one of the twenty-second aspect described above to the thirtieth aspect described above.

According to a thirty-second aspect of the present disclosure, at the substrate opening formation step, a mask protection layer may be provided on a surface of the mask layer opposite the mask substrate, as for the method of manufacturing the vapor deposition mask according to any one of the twenty-second aspect described above to the thirty-first aspect described above.

According to a thirty-third aspect of the present disclosure, a mask protection layer formation step of forming the mask protection layer on the surface of the mask layer opposite the mask substrate before the substrate opening formation step after the mask layer formation step, and a mask protection layer removal step of removing the mask protection layer before the through-hole formation step after the substrate opening formation step may be further included, as for the method of manufacturing the vapor deposition mask according to the thirty-second aspect described above.

According to a thirty-fourth aspect of the present disclosure, a thickness of the mask intermediate layer may be less than a thickness of the mask body layer, as for the method of manufacturing the vapor deposition mask according to any one of the twenty-second aspect described above to the thirty-third aspect described above.

According to a thirty-fifth aspect of the present disclosure, the substrate opening formation step may include a resist layer formation step of forming a resist layer that includes a resist opening on a surface of the mask substrate opposite the mask layer and a substrate etching step of forming the substrate opening by etching the mask substrate through the resist opening, as for the method of manufacturing the vapor deposition mask according to any one of the twenty-second aspect described above to the thirty-fourth aspect described above.

According to a thirty-sixth aspect of the present disclosure, the mask intermediate layer may contain a material that is capable of ensuring adhesion to the mask substrate and that has resistance against an etching medium that is used at the substrate etching step, as for the method of manufacturing the vapor deposition mask according to the thirty-fifth aspect described above.

According to a thirty-seventh aspect of the present disclosure, the mask intermediate layer may be in contact with the mask body layer and is in contact with the mask substrate, as for the method of manufacturing the vapor deposition mask according to the thirty-sixth aspect described above.

According to a thirty-eighth aspect of the present disclosure, at the mask layer formation step, the mask intermediate layer may be formed by performing a sputtering process, as for the method of manufacturing the vapor deposition mask according to any one of the twenty-second aspect described above to the thirty-seventh aspect described above.

According to a thirty-ninth aspect of the present disclosure, at the mask layer formation step, the mask intermediate layer may be formed by performing a vapor deposition process, as for the method of manufacturing the vapor deposition mask according to any one of the twenty-second aspect described above to the thirty-seventh aspect described above.

According to a fortieth aspect of the present disclosure, the mask layer may include two or more of the through-holes, and the two or more of the through-holes may be located in the substrate opening in a plan view, as for the method of manufacturing the vapor deposition mask according to any one of the twenty-second aspect described above to the thirty-ninth aspect described above.

According to a forty-first aspect of the present disclosure, the mask layer may include two or more through-hole groups that are formed by the two or more of the through-holes, and the two or more through-hole groups may be located in the substrate opening in a plan view, as for the method of manufacturing the vapor deposition mask according to the fortieth aspect described above.

According to a forty-second aspect of the present disclosure, the mask substrate may include two or more of the substrate openings, the mask layer may include two or more through-hole groups that are formed by the two or more of the through-holes, and the two or more through-hole groups may be located in the substrate openings in a plan view, as for the method of manufacturing the vapor deposition mask according to the fortieth aspect described above.

According to a forty-third aspect of the present disclosure, the mask substrate may include two or more of the substrate openings, the mask layer may include two or more through-hole groups that are formed by the two or more of the through-holes, and a corresponding one of the through-hole groups may be located in each substrate opening in a plan view, as for the method of manufacturing the vapor deposition mask according to the fortieth aspect described above.

According to a forty-fourth aspect of the present disclosure, the substrate opening may have a rectangular shape in a plan view, and curved portions may be provided at four corners of a contour of the substrate opening in a plan view, as for the method of manufacturing the vapor deposition mask according to any one of the twenty-second aspect described above to the forty-third aspect described above.

According to a forty-fifth aspect of the present disclosure, a step of forming a first alignment mark on a surface of the mask substrate opposite the mask layer may be further included, as for the method of manufacturing the vapor deposition mask according to any one of the twenty-second aspect described above to the forty-fourth aspect described above.

According to a forty-sixth aspect of the present disclosure, the mask substrate may include a substrate body that defines the substrate opening and an inner projecting portion that projects inward from the substrate body in a plan view, and the first alignment mark may be located on the inner projecting portion, as for the method of manufacturing the vapor deposition mask according to the forty-fifth aspect described above.

According to a forty-seventh aspect of the present disclosure, a step of forming a second alignment mark at a position nearer than the first alignment mark to the through-hole may be further included, as for the method of manufacturing the vapor deposition mask according to the forty-fifth aspect described above or the forty-sixth aspect described above.

According to a forty-eighth aspect of the present disclosure, the mask layer may include two or more of the through-holes, two or more through-hole groups that are formed by the two or more of the through-holes and a mask sash bar that is provided between the through-hole groups adjacent to each other, and the second alignment mark may be located on the mask sash bar, as for the method of manufacturing the vapor deposition mask according to the forty-fourth aspect described above.

According to a forty-ninth aspect of the present disclosure, the mask sash bar may include a first mask sash bar and a second mask sash bar that extend in respective directions perpendicular to each other in a plan view, and the second alignment mark may be located at an intersecting portion at which the first mask sash bar and the second mask sash bar intersect with each other, as for the method of manufacturing the vapor deposition mask according to the forty-eighth aspect described above.

According to a fiftieth aspect of the present disclosure, an outer edge of the mask body layer may be located inside an outer edge of the mask intermediate layer in a plan view, as for the method of manufacturing the vapor deposition mask according to any one of the twenty-second aspect described above to the forty-ninth aspect described above.

According to a fifty-first aspect of the present disclosure, the mask body layer may include two or more body islands, and a groove that extends through the mask body layer may be located between two of the body islands adjacent to each other, as for the method of manufacturing the vapor deposition mask according to any one of the twenty-second aspect described above to the fiftieth aspect described above.

The twenty-second aspect described above to the fifty-first aspect described above may be the vapor deposition masks that are manufactured by using the methods of manufacturing the vapor deposition masks according to the twenty-second aspect to the fifty-first aspect.

According to a fifty-second aspect of the present disclosure, a method of manufacturing an organic device includes a vapor deposition mask preparation step of preparing the vapor deposition mask by using the method according to any one of the twenty-second aspect described above to the fifty-first aspect described above, a close contact step of causing the first surface of the mask layer of the vapor deposition mask to come into close contact with a vapor deposition substrate, and a vapor deposition step of forming a vapor deposition layer in a manner in which a vapor deposition material is deposited on the vapor deposition substrate via the through-hole of the vapor deposition mask.

The fifty-second aspect described above may be the organic device that is manufactured by using the method of manufacturing the organic device according to the fifty-second aspect.

According to a fifty-third aspect of the present disclosure, a method of manufacturing a framed vapor deposition mask includes a vapor deposition mask preparation step of preparing the vapor deposition mask by using the method according to any one of the twenty-second aspect described above to the fifty-first aspect described above, and a frame attachment step of attaching a frame to the mask substrate of the vapor deposition mask.

The fifty-third aspect described above may be the framed vapor deposition mask that is manufactured by using the method of manufacturing the framed vapor deposition mask according to the fifty-third aspect.

An embodiment of the present disclosure will now be described in detail with reference to the drawings. The embodiment described below is an example of the embodiment of the present disclosure, and the present disclosure is not limited only to the embodiment.

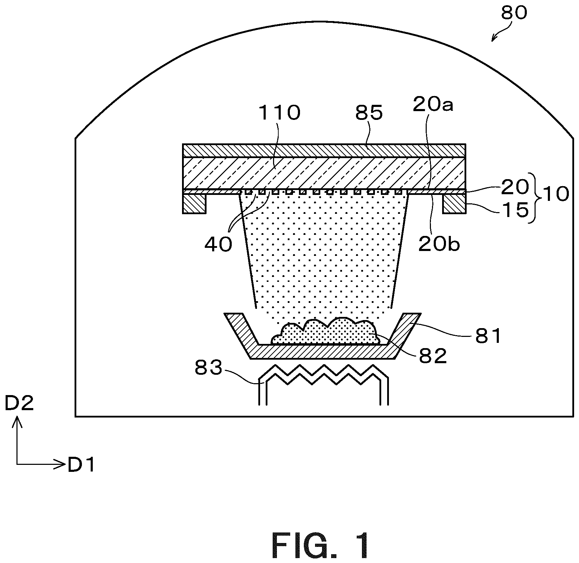

A vapor deposition apparatus 80 for performing a vapor deposition process in which a vapor deposition material is deposited on an object will be described with reference to Fig. 1. As illustrated in Fig. 1, the vapor deposition apparatus 80 may include a vapor deposition source (such as a crucible 81), a heater 83, and a vapor deposition mask 10. The vapor deposition apparatus 80 may further include an exhaust means (not illustrated). The exhaust means can reduce pressure in the vapor deposition apparatus 80 to that in a vacuum atmosphere. The crucible 81 is provided in the vapor deposition apparatus 80 and is configured to contain a vapor deposition material 82 such as an organic light-emitting material. The heater 83 is configured to heat the crucible 81. The crucible 81 is heated in the vacuum atmosphere, and consequently, the vapor deposition material 82 is vaporized.

The vapor deposition mask 10 is disposed in the vapor deposition apparatus 80 so as to face the crucible 81. The vapor deposition mask 10 may be disposed above the crucible 81. A vapor deposition substrate 110 is disposed so as to face the vapor deposition mask 10. The vapor deposition substrate 110 is an object to which the vapor deposition material 82 is attached. The vapor deposition substrate 110 may be disposed above the vapor deposition mask 10. The vapor deposition material that comes from the crucible 81 passes through through-holes 40 of the vapor deposition mask 10 described later and is attached to the vapor deposition substrate 110.

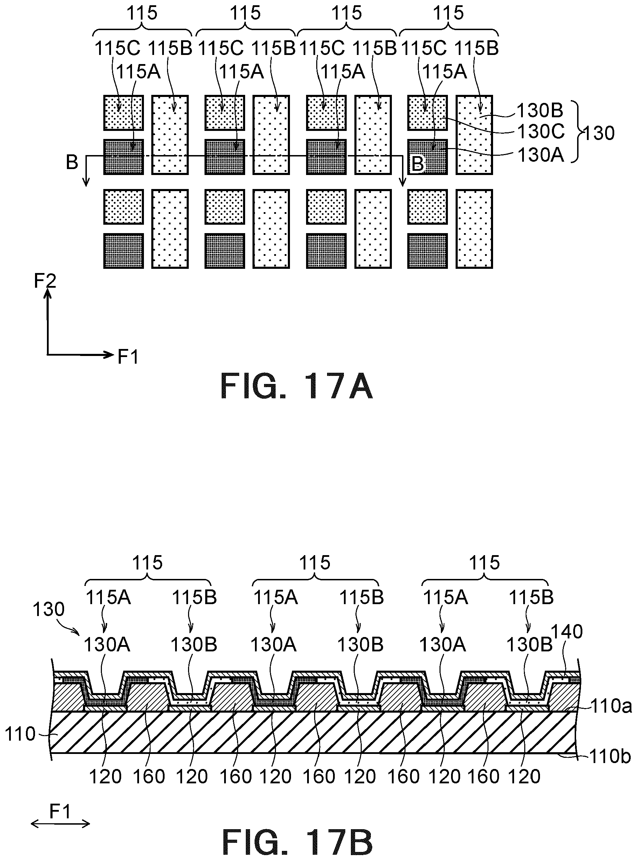

As illustrated in Fig. 1, the vapor deposition apparatus 80 may include a magnet 85 that is disposed on a surface of the vapor deposition substrate 110 opposite the vapor deposition mask 10. The magnetic force of the magnet 85 enables the vapor deposition mask 10 to be attracted toward the magnet 85, and the vapor deposition mask 10 can be brought into close contact with the vapor deposition substrate 110. This enables shadow (described later) to be inhibited from occurring at a vapor deposition step. For this reason, the precision of the shape and the precision of the position of a vapor deposition layer (or organic layers 130A, 130B, and 130C of an organic device 100 described later, see Fig. 17A and Fig. 17B) that is formed by using the vapor deposition material 82 that is attached to the vapor deposition substrate 110 can be improved. A cooling plate (not illustrated) that cools the vapor deposition substrate 110 during vapor deposition may be interposed between the vapor deposition substrate 110 and the magnet 85.

The vapor deposition mask 10 according to the present embodiment will now be described in more detail with reference to Fig. 1 to Fig. 5B.

As illustrated in Fig. 1 to Fig. 3, the vapor deposition mask 10 may include a mask layer 20 that includes the through-holes 40 described later and a mask substrate 15 that supports the mask layer 20. The mask substrate 15 may be located on a second surface 20b of the mask layer 20 described later.

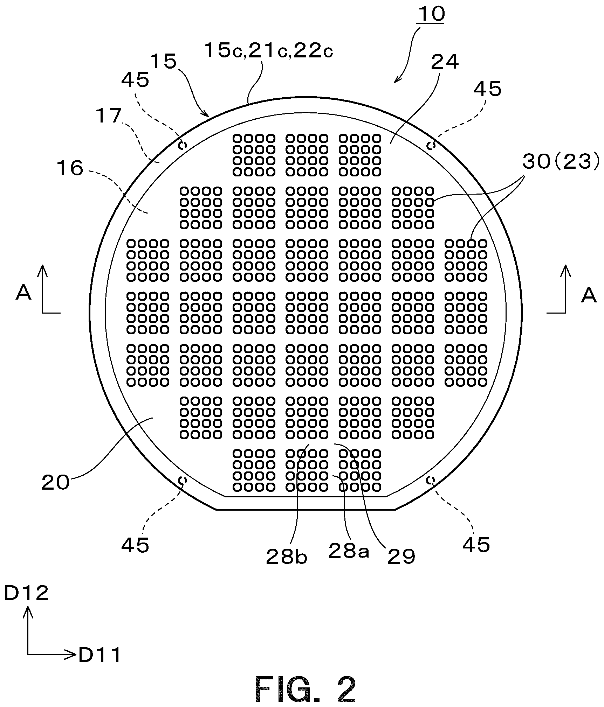

As illustrated in Fig. 2, the vapor deposition mask 10 according to the present embodiment may have the same planar shape as a silicon wafer that is used for manufacturing semiconductor when viewed in a direction perpendicular to a first surface 20a described later (referred to below as "in a plan view"). In this case, both of the mask layer 20 and the mask substrate 15 may have the same shape as the silicon wafer. The silicon wafer may have a planar shape (see Fig. 2) obtained by linearly cutting a portion of a circle, which is called an orientation flat as in a typical wafer shape. Alternatively, the silicon wafer may have a planar shape obtained by cutting a portion of a circle in a recessed shape, which is called a notch.

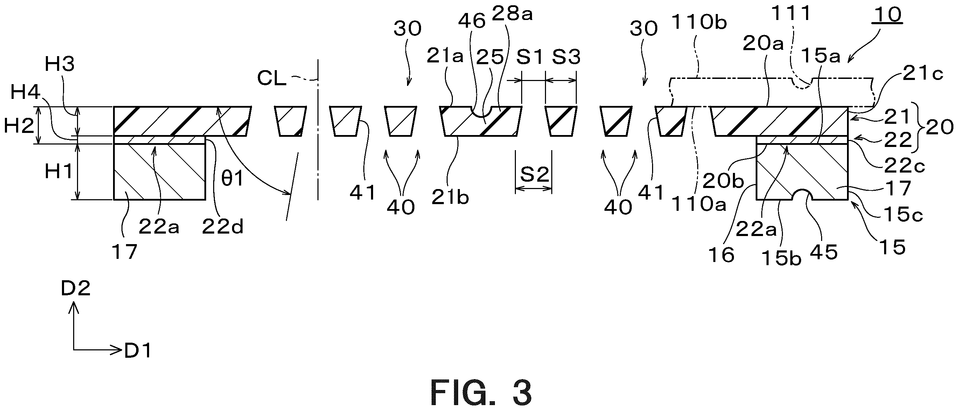

As illustrated in Fig. 3, the mask substrate 15 may include a first substrate surface 15a that faces the mask layer 20 and a second substrate surface 15b that is located opposite the first substrate surface 15a. The mask layer 20 (more specifically, a mask intermediate layer 22 described later) may be attached or fixed to the first substrate surface 15a. The mask layer 20 and the mask substrate 15 may be attached to each other by using a layer (such as the mask intermediate layer 22 described later) that is formed by performing, for example, a sputtering process or a vapor deposition process described later such that the mask layer 20 is not separatable. Fig. 3 schematically illustrates a section taken along a line A-A in Fig. 2 where the number of through-hole groups 30 and the number of the through-holes 40 are reduced to make the figure easy to understand.

As illustrated in Fig. 2 and Fig. 3, the mask substrate 15 may include a substrate opening 16 from which the through-holes 40 of the mask layer 20 are exposed. The substrate opening 16 extends from the first substrate surface 15a to the second substrate surface 15b through the mask substrate 15. In a plan view, a through-hole 40 may be located in the substrate opening 16, or the multiple through-holes 40 may be located therein. According to an embodiment, the mask substrate 15 may have a frame shape in a plan view. As illustrated in Fig. 2, the mask substrate 15 may include a substrate frame body 17 that is located outside the through-hole groups 30 and that has a planar shape that extends along an outer edge 15c of the mask substrate 15. The substrate frame body 17 is an example of a substrate body. The substrate opening 16 may be defined inside the substrate frame body 17. As illustrated in Fig. 2, the substrate opening 16 may have a contour similar to the outer edge 15c of the mask substrate 15 or a circular contour in a plan view.

The diameter of the mask substrate 15 is not particularly limited but may be, for example, 150 mm (6 inches), 200 mm (8 inches), 300 mm (12 inches), or 450 mm (18 inches).

The thickness H1 of the mask substrate 15 is not particularly limited but may be 0.625 mm in the case where the diameter is 150 mm or may be 0.725 mm in the case where the diameter is 200 mm. The thickness H1 may be 0.775 mm in the case where the diameter is 300 mm.

The mask substrate 15 may contain silicon. For example, in the case where the vapor deposition substrate 110 is a glass substrate, the thermal expansion coefficient of the mask substrate 15 can be adjusted to a value equal or close to that of the glass substrate. In some cases, the precision of the shapes and the precision of the positions of the organic layers 130A, 130B, and 130C that are formed on the vapor deposition substrate 110 reduces due to a difference in thermal expansion coefficient between the vapor deposition mask 10 that includes the mask layer 20 and the vapor deposition substrate 110 at the vapor deposition step. The reduction is referred to below as precision reduction in some cases. The thermal expansion coefficient of the mask substrate 15 is adjusted to a value equal or close to that of the glass substrate, and consequently, the precision reduction can be inhibited from being made. In the case where the vapor deposition substrate 110 is a silicon substrate, the mask substrate 15 can be composed of the same kind of material or the same material as that of the vapor deposition substrate 110. In this case, the difference between the thermal expansion coefficient of the mask substrate 15 and the thermal expansion coefficient of the vapor deposition substrate 110 can be reduced. In addition, the thermal expansion coefficient of the mask substrate 15 and the thermal expansion coefficient of the vapor deposition substrate 110 can be equal to each other. This enables the precision reduction to be further inhibited from being made.

As illustrated in Fig. 3, the mask layer 20 may include the first surface 20a and the second surface 20b that is located opposite the first surface 20a and that faces the mask substrate 15. The first surface 20a may come into close contact with the vapor deposition substrate 110 during vapor deposition. The second surface 20b may be attached to the mask substrate 15.

For example, the thickness H2 of the mask layer 20 may be 2 µm or more, may be 3 µm or more, may be 4 µm or more, or may be 5 µm or more. When the thickness H2 is 2 µm or more, the mechanical strength of the mask layer 20 can be ensured, and deformation or damage can be reduced during handing. For example, the thickness H2 may be 6 µm or less, may be 7 µm or less, may be 8 µm or less, or may be 9 µm or less. When the thickness H2 is 9 µm or less, shadow can be inhibited from occurring. The range of the thickness H2 may be determined by using a first group consisting of 2 µm, 3 µm, 4 µm, and 5 µm and/or a second group consisting of 6 µm, 7 µm, 8 µm, and 9 µm. The range of the thickness H2 may be determined by using a combination of a freely selected one of values in the first group described above and a freely selected one of values in the second group described above. The range of the thickness H2 may be determined by using a combination of freely selected two of values in the first group described above. The range of the thickness H2 may be determined by using a combination of freely selected two of values in the second group described above. For example, the range may be 2 µm or more and 9 µm or less, may be 2 µm or more and 8 µm or less, may be 2 µm or more and 7 µm or less, may be 2 µm or more and 6 µm or less, may be 2 µm or more and 5 µm or less, may be 2 µm or more and 4 µm or less, may be 2 µm or more and 3 µm or less, may be 3 µm or more and 9 µm or less, may be 3 µm or more and 8 µm or less, may be 3 µm or more and 7 µm or less, may be 3 µm or more and 6 µm or less, may be 3 µm or more and 5 µm or less, may be 3 µm or more and 4 µm or less, may be 4 µm or more and 9 µm or less, may be 4 µm or more and 8 µm or less, may be 4 µm or more and 7 µm or less, may be 4 µm or more and 6 µm or less, may be 4 µm or more and 5 µm or less, may be 5 µm or more and 9 µm or less, may be 5 µm or more and 8 µm or less, may be 5 µm or more and 7 µm or less, may be 5 µm or more and 6 µm or less, may be 6 µm or more and 9 µm or less, may be 6 µm or more and 8 µm or less, may be 6 µm or more and 7 µm or less, may be 7 µm or more and 9 µm or less, may be 7 µm or more and 8 µm or less, or may be 8 µm or more and 9 µm or less.

According to an embodiment, the mask layer 20 may include a resin layer 21 that is near the first surface 20a and the mask intermediate layer 22 that is nearer than the resin layer 21 to the second surface 20b. The resin layer 21 may form the first surface 20a. The resin layer 21 is an example of a mask body layer and may be referred to as a resin body layer. The resin layer 21 may be attached to and is stacked on the mask intermediate layer 22. The resin layer 21 may contain a resin material. The material of the resin layer 21 is not particularly limited, but an example thereof may be polyimide (PI). The mask intermediate layer 22 is located between the resin layer 21 and the mask substrate 15. The thickness H4 of the mask intermediate layer 22 may be less than the thickness H3 of the resin layer 21. The resin layer 21 may be formed in a manner in which a liquid resin material is applied and dried as described later. The mask intermediate layer 22 may be formed by performing the sputtering process as described later.

The resin layer 21 may include a first resin layer surface 21a that is located near the first surface 20a and a second resin layer surface 21b that is located near the second surface 20b. The first resin layer surface 21a may form the first surface 20a. The second resin layer surface 21b may face the mask intermediate layer 22. The through-holes 40 extend through the resin layer 21.

The mask intermediate layer 22 may include a body region portion 22a that is located between the resin layer 21 and the substrate frame body 17 and a mask layer opening 22d that is formed along the substrate opening 16 in a plan view. The mask layer opening 22d may extend through the mask intermediate layer 22. The mask layer opening 22d may have the same planar shape as that of the substrate opening 16.

As illustrated in Fig. 3, an outer edge 21c of the resin layer 21 may overlap an outer edge 22c of the mask intermediate layer 22 in a plan view. The outer edge 21c of the resin layer 21 may entirely overlap the outer edge 22c of the mask intermediate layer 22. The outer edge 21c of the resin layer 21 and the outer edge 22c of the mask intermediate layer 22 may overlap the outer edge 15c of the mask substrate 15 described above in a plan view. The outer edge 21c of the resin layer 21 and the outer edge 22c of the mask intermediate layer 22 may entirely overlap the outer edge 15c of the mask substrate 15.

For example, the mask intermediate layer 22 may be capable of ensuring adhesion between the resin layer 21 and the mask substrate 15. The mask intermediate layer 22 may have resistance against an etching medium that is used at a substrate etching step described later. More specifically, the mask intermediate layer 22 may be capable of reducing the erosion of an etching medium.

For example, the thickness H3 of the resin layer 21 may be 0.5 µm or more, may be 1.0 µm or more, may be 1.5 µm or more, or may be 2.0 µm or more. When the thickness H3 is 0.5 µm or more, the resin layer 21 that is capable of ensuring the mechanical strength and that is capable of reducing deformation or damage during handing can be stably formed by performing the plating process described later. For example, the thickness H3 may be 4.2 µm or less, may be 4.4 µm or less, may be 4.6 µm or less, or may be 4.8 µm or less. When the thickness H3 is 4.8 µm or less, the resin layer 21 can be efficiently formed. The range of the thickness H3 may be determined by using a first group consisting of 0.5 µm, 1.0 µm, 1.5 µm and 2.0 µm and/or a second group consisting of 4.2 µm, 4.4 µm, 4.6 µm, and 4.8 µm. The range of the thickness H3 may be determined by using a combination of a freely selected one of values in the first group described above and a freely selected one of values in the second group described above. The range of the thickness H3 may be determined by using a combination of freely selected two of values in the first group described above. The range of the thickness H3 may be determined by using a combination of freely selected two of values in the second group described above. For example, the range may be 0.5 µm or more and 4.8 µm or less, may be 0.5 µm or more and 4.6 µm or less, may be 0.5 µm or more and 4.4 µm or less, may be 0.5 µm or more and 4.2 µm or less, may be 0.5 µm or more and 2.0 µm or less, may be 0.5 µm or more and 1.5 µm or less, may be 0.5 µm or more and 1.0 µm or less, may be 1.0 µm or more and 4.8 µm or less, may be 1.0 µm or more and 4.6 µm or less, may be 1.0 µm or more and 4.4 µm or less, may be 1.0 µm or more and 4.2 µm or less, may be 1.0 µm or more and 2.0 µm or less, may be 1.0 µm or more and 1.5 µm or less, may be 1.5 µm or more and 4.8 µm or less, may be 1.5 µm or more and 4.6 µm or less, may be 1.5 µm or more and 4.4 µm or less, may be 1.5 µm or more and 4.2 µm or less, may be 1.5 µm or more and 2.0 µm or less, may be 2.0 µm or more and 4.8 µm or less, may be 2.0 µm or more and 4.6 µm or less, may be 2.0 µm or more and 4.4 µm or less, may be 2.0 µm or more and 4.2 µm or less, may be 4.2 µm or more and 4.8 µm or less, may be 4.2 µm or more and 4.6 µm or less, may be 4.2 µm or more and 4.4 µm or less, may be 4.4 µm or more and 4.8 µm or less, may be 4.4 µm or more and 4.6 µm or less, or may be 4.6 µm or more and 4.8 µm or less.

Alternatively, for example, the thickness H3 of the resin layer 21 may be 3.2 µm or more, may be 3.4 µm or more, may be 3.6 µm or more, or may be 3.8 µm or more. When the thickness H3 is 3.2 µm or more, the resin layer 21 that is capable of ensuring the mechanical strength and that is capable of reducing deformation or damage during handling can be stably formed by performing the plating process described later. For example, the thickness H3 may be 4.2 µm or less, may be 4.4 µm or less, may be 4.6 µm or less, or may be 4.8 µm or less. When the thickness H3 is 4.8 µm or less, the resin layer 21 can be efficiently formed. The range of the thickness H3 may be determined by using a first group consisting of 3.2 µm, 3.4 µm, 3.6 µm, and 3.8 µm and/or a second group consisting of 4.2 µm, 4.4 µm, 4.6 µm, and 4.8 µm. The range of the thickness H3 may be determined by using a combination of a freely selected one of values in the first group described above and a freely selected one of values in the second group described above. The range of the thickness H3 may be determined by using a combination of freely selected two of values in the first group described above. The range of the thickness H3 may be determined by using a combination of freely selected two of values in the second group described above. For example, the range may be 3.2 µm or more and 4.8 µm or less, may be 3.2 µm or more and 4.6 µm or less, may be 3.2 µm or more and 4.4 µm or less, may be 3.2 µm or more and 4.2 µm or less, may be 3.2 µm or more and 3.8 µm or less, may be 3.2 µm or more and 3.6 µm or less, may be 3.2 µm or more and 3.4 µm or less, may be 3.4 µm or more and 4.8 µm or less, may be 3.4 µm or more and 4.6 µm or less, may be 3.4 µm or more and 4.4 µm or less, may be 3.4 µm or more and 4.2 µm or less, may be 3.4 µm or more and 3.8 µm or less, may be 3.4 µm or more and 3.6 µm or less, may be 3.6 µm or more and 4.8 µm or less, may be 3.6 µm or more and 4.6 µm or less, may be 3.6 µm or more and 4.4 µm or less, may be 3.6 µm or more and 4.2 µm or less, may be 3.6 µm or more and 3.8 µm or less, may be 3.8 µm or more and 4.8 µm or less, may be 3.8 µm or more and 4.6 µm or less, may be 3.8 µm or more and 4.4 µm or less, may be 3.8 µm or more and 4.2 µm or less, may be 4.2 µm or more and 4.8 µm or less, may be 4.2 µm or more and 4.6 µm or less, may be 4.2 µm or more and 4.4 µm or less, may be 4.4 µm or more and 4.8 µm or less, may be 4.4 µm or more and 4.6 µm or less, or may be 4.6 µm or more and 4.8 µm or less.

For example, the thickness H4 of the mask intermediate layer 22 may be 50 nm or more, may be 60 nm or more, may be 70 nm or more, or may be 80 nm or more. When the thickness H4 is 50 nm or more, the mask intermediate layer 22 can be stably formed by performing the sputtering process described later. For example, the thickness H4 may be 104 nm or less, may be 106 nm or less, may be 108 nm or less, or may be 110 nm or less. When the thickness H4 is 110 nm or less, the mask intermediate layer 22 can be efficiently formed. The range of the thickness H4 may be determined by using a first group consisting of 50 nm, 60 nm, 70 nm, and 80 nm and/or a second group consisting of 104 nm, 106 nm, 108 nm, and 110 nm. The range of the thickness H4 may be determined by using a combination of a freely selected one of values in the first group described above and a freely selected one of values in the second group described above. The range of the thickness H4 may be determined by using a combination of freely selected two of values in the first group described above. The range of the thickness H4 may be determined by using a combination of freely selected two of values in the second group described above. For example, the range may be 50 nm or more and 110 nm or less, may be 50 nm or more and 108 nm or less, may be 50 nm or more and 106 nm or less, may be 50 nm or more and 104 nm or less, may be 50 nm or more and 80 nm or less, may be 50 nm or more and 70 nm or less, may be 50 nm or more and 60 nm or less, may be 60 nm or more and 110 nm or less, may be 60 nm or more and 108 nm or less, may be 60 nm or more and 106 nm or less, may be 60 nm or more and 104 nm or less, may be 60 nm or more and 80 nm or less, may be 60 nm or more and 70 nm or less, may be 70 nm or more and 110 nm or less, may be 70 nm or more and 108 nm or less, may be 70 nm or more and 106 nm or less, may be 70 nm or more and 104 nm or less, may be 70 nm or more and 80 nm or less, may be 80 nm or more and 110 nm or less, may be 80 nm or more and 108 nm or less, may be 80 nm or more and 106 nm or less, may be 80 nm or more and 104 nm or less, may be 104 nm or more and 110 nm or less, may be 104 nm or more and 108 nm or less, may be 104 nm or more and 106 nm or less, may be 106 nm or more and 110 nm or less, may be 106 nm or more and 108 nm or less, or may be 108 nm or more and 110 nm or less.

Alternatively, for example, the thickness H4 of the mask intermediate layer 22 may be 90 nm or more, may be 92 nm or more, may be 94 nm or more, or may be 96 nm or more. When the thickness H4 is 90 nm or more, the mask intermediate layer 22 can be more stably formed by performing the sputtering process described later. For example, the thickness H4 may be 104 nm or less, may be 106 nm or less, may be 108 nm or less, or may be 110 nm or less. When the thickness H4 is 110 nm or less, the mask intermediate layer 22 can be efficiently formed. The range of the thickness H4 may be determined by using a first group consisting of 90 nm, 92 nm, 94 nm, and 96 nm and/or a second group consisting of 104 nm, 106 nm, 108 nm, and 110 nm. The range of the thickness H4 may be determined by using a combination of a freely selected one of values in the first group described above and a freely selected one of values in the second group described above. The range of the thickness H4 may be determined by using a combination of freely selected two of values in the first group described above. The range of the thickness H4 may be determined by using a combination of freely selected two of values in the second group described above. For example, the range may be 90 nm or more and 110 nm or less, may be 90 nm or more and 108 nm or less, may be 90 nm or more and 106 nm or less, may be 90 nm or more and 104 nm or less, may be 90 nm or more and 96 nm or less, may be 90 nm or more and 94 nm or less, may be 90 nm or more and 92 nm or less, may be 92 nm or more and 110 nm or less, may be 92 nm or more and 108 nm or less, may be 92 nm or more and 106 nm or less, may be 92 nm or more and 104 nm or less, may be 92 nm or more and 96 nm or less, may be 92 nm or more and 94 nm or less, may be 94 nm or more and 110 nm or less, may be 94 nm or more and 108 nm or less, may be 94 nm or more and 106 nm or less, may be 94 nm or more and 104 nm or less, may be 94 nm or more and 96 nm or less, may be 96 nm or more and 110 nm or less, may be 96 nm or more and 108 nm or less, may be 96 nm or more and 106 nm or less, may be 96 nm or more and 104 nm or less, may be 104 nm or more and 110 nm or less, may be 104 nm or more and 108 nm or less, may be 104 nm or more and 106 nm or less, may be 106 nm or more and 110 nm or less, may be 106 nm or more and 108 nm or less, or may be 108 nm or more and 110 nm or less.

The resin layer 21 may contain a resin material. The resin material is not particularly limited, but an example thereof may be polyimide (PI).

The material of the mask intermediate layer 22 is not particularly limited provided that the material is capable of ensuring the adhesion between the resin layer 21 and the mask substrate 15 and is capable of reducing the erosion of the etching medium that is used at the substrate etching step described later. For example, the mask intermediate layer 22 may contain gold (Au), aluminum (Al), chromium (Cr), nickel (Ni), titanium (Ti), titanium nitride (TiN), an aluminum alloy (Al-Nd) that contains neodymium, a silicon oxide (SiO) or a silicon dioxide (SiO₂). In the case where the mask intermediate layer 22 is composed of an aluminum alloy that contains neodymium, the aluminum alloy may contain neodymium in an amount of 0.5 atomic% or more and 2 atomic% or less. Atomic% described herein is obtained by analyzing the composition of the mask intermediate layer 22 by using an XPS method. The XPS method is a method in which knowledge about the kinds or amounts of constituent elements in a region in a range of several nanometers from a surface of a sample is obtained as a result of measurement of the energy distribution of photoelectrons that are emitted from the sample when the sample is irradiated with an X-ray. In this case, the amount of each constituent element is proportional to a peak area value that is calculated by integrating the area of a peak that corresponds to the constituent element in a spectrum that is measured by X-ray photoelectron spectroscopy. Accordingly, the peak area values that correspond to the respective constituent elements are first calculated. Subsequently, the sum of the peak area values of the constituent elements is calculated, subsequently, the peak area value of the target constituent element is divided by the sum and is multiplied by 100, and consequently, the atomic% of the target constituent element can be calculated. Relationships between the amounts of the constituent elements and the peak area values differ from each other depending on, for example, sensitivity to the X-ray with respect to every constituent element. In this case, the peak area values of the constituent elements may be multiplied by a relative sensitivity coefficient for correcting a difference in sensitivity, corrected peak area values may be calculated, and the sum and atomic% described above may be subsequently calculated.

The mask layer 20 may include the through-holes 40. The mask layer 20 may include two or more through-holes 40. The through-holes 40 may extend through the mask layer 20. According to the present embodiment, the through-holes 40 extend through the resin layer 21. That is, the through-holes 40 extend from the first resin layer surface 21a (or the first surface 20a) to the second resin layer surface 21b through the resin layer 21.

The opening dimension of each through-hole 40 in a predetermined direction (such as a first direction D11 or a second direction D12 described later) at the second resin layer surface 21b may be larger than the opening dimension of each through-hole 40 in the predetermined direction at the first resin layer surface 21a. According to an embodiment, the sectional openings of the through-holes 40 in a direction parallel with the first resin layer surface 21a may be gradually enlarged in a direction from the first resin layer surface 21a toward the second resin layer surface 21b. In other words, the sectional areas of the through-holes 40 in a section parallel with the first resin layer surface 21a at positions in the normal direction of the mask layer 20 may be gradually increased in the direction from the first resin layer surface 21a toward the second resin layer surface 21b. In this case, the through-holes 40 may include wall surfaces 41 that are gradually separated from the central axes CL of the through-holes 40 in direction from the first resin layer surface 21a toward the second resin layer surface 21b. In an example illustrated in Fig. 3, the wall surfaces 41 of the through-holes 40 are linearly inclined with respect to the central axes CL so as to be separated from the central axes CL in direction from the first resin layer surface 21a toward the second resin layer surface 21b.

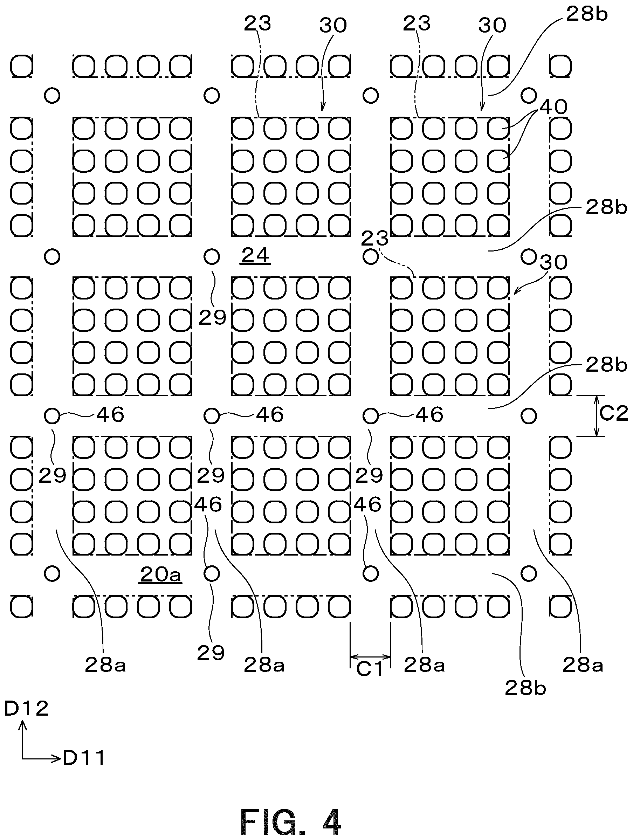

As illustrated in Fig. 2 and Fig. 4, the through-holes 40 may form two or more through-hole groups 30. The through-hole groups 30 are located in the substrate opening 16 of the mask substrate 15 in a plan view. That is, one of the through-hole groups 30 (or effective regions 23 described later) may be located in the substrate opening 16, or the multiple through-hole groups 30 (or the multiple effective regions 23) may be located therein. All of the through-hole groups 30 may be located in the single substrate opening 16. As illustrated in Fig. 4, each through-hole group 30 may be formed so that two or more through-holes 40 for a group. The through-hole groups 30 correspond to a term that means an aggregation of the multiple through-holes 40 that are regularly arranged. The through-holes 40 that form one of the through-hole groups 30 and that are on outer edges thereof are located at outermost positions among the multiple through holes 40 that are regularly arranged in the same manner. The through-holes 40 that are regularly arranged and that are configured such that the vapor deposition material 82 is to pass through may not be present outside the through-holes 40 that are located at the outermost positions in one of the through-hole groups 30.

As illustrated in Fig. 2 and Fig. 4, mask sash bars 28a and 28b may be provided between the through-hole groups 30 adjacent to each other. The mask sash bars 28a and 28b may not include the through-holes 40 that are configured such that the vapor deposition material 82 is to pass through. The mask sash bars 28a and 28b may include first mask sash bars 28a and second mask sash bars 28b that extend in respective directions perpendicular to each other. The first mask sash bars 28a may extend in the second direction D12, and the second mask sash bars 28b may extend in the first direction D11. The multiple first mask sash bars 28a may be arranged in the first direction D11. The multiple second mask sash bars 28b may be arranged in the second direction D12. The first mask sash bars 28a and the second mask sash bars 28b intersect with each other at intersecting portions 29. The mask sash bars 28a and 28b may include through-holes and recessed portions (not illustrated) for other purposes. The through-holes and the recessed portions for the other purposes may not be regularly arranged unlike the through-holes 40 and may be thought so as not to be included in the through-hole groups 30. The mask sash bars 28a and 28b may form a portion of a surrounding region 24 described later.

As illustrated in Fig. 4, the multiple through-hole groups 30 may be arranged in a predetermined interval (a predetermined pitch). The through-hole groups 30 may be arranged in a predetermined interval in the first direction D11 and may be arranged in a predetermined interval in the second direction D12. The through-hole groups 30 may be arranged with the first mask sash bars 28a interposed therebetween in the first direction D11 and may be arranged with the second mask sash bars 28b interposed therebetween in the second direction D12. The array pitch of the through-hole groups 30 in the first direction D11 may differ from or may be equal to that in the second direction D12. In an example illustrated in Fig. 4, the array pitch in the first direction D11 is equal to the array pitch in the second direction D12. As illustrated in Fig. 4, the through-hole groups 30 may be arranged in parallel. That is, the through-hole groups 30 that are arranged in a row in the first direction D11 and the through-hole groups 30 that are arranged in another row adjacent to the row in the second direction D12 may be aligned in the second direction D12.

In Fig. 4, distances between the through-hole groups 30 adjacent to each other in the first direction D11 are illustrated as C1. The distances C1 correspond to the widths of the first mask sash bars 28a. Distances between the through-hole groups 30 adjacent to each other in the second direction D12 are illustrated as C2. The distances C2 correspond to the widths of the second mask sash bars 28b. The distances C1 and the distances C2 may differ from each other, but the distances C1 and the distances C2 are equal to each other in the example illustrated in Fig. 4. The distances C1 and C2 may be set depending on the width of a dicing saw that is used when the vapor deposition substrate 110 (see Fig. 17A) on which multiple organic devices 100 that include, for example, the organic layers 130A, 130B, and 130C are deposited is cut for every organic device 100. The vapor deposition substrate 110 may be cut by single sewing for dividing the vapor deposition substrate 110 by single cutting of regions between the organic devices 100 adjacent to each other. As for the single sewing, the vapor deposition substrate 110 can be efficiently divided in the perspective that the vapor deposition substrate 110 can be divided by the single cutting. The single sewing may be used in the case where the distances C1 and the distances C2 are relatively short. In the case where the single sewing is used, the distances C1 and the distances C2 may be equal or close to the width of the dicing saw. Instead of the single sawing, the vapor deposition substrate 110 may be cut by double sawing for dividing the vapor deposition substrate 110 by double cutting of the regions between the organic devices 100 adjacent to each other. For example, the double cutting that is performed includes cutting at a position along one of edges of each organic device 100 and cutting at a position along another edge of each organic device 100. The double sawing may be used in the case where the distances C1 and the distances C2 are relatively long, or in the case where the width of the dicing saw is relatively narrow. In the case where the double sawing is used, the use of the double sawing that has the narrow width enables a time for cutting the vapor deposition substrate 110 to be reduced.

For example, the distances C1 and C2 may be 30 µm or more, may be 50 µm or more, may be 100 µm or more, and may be 150 µm or more. When the distances C1 and C2 are 30 µm or more, a cutting width for cutting the vapor deposition substrate 110 by the single sewing with the dicing saw can be ensured, and the strength of the vapor deposition mask 10 can be improved. For example, the distances C1 and C2 may be 240 µm or less, may be 260 µm or less, may be 280 µm or less, and may be 300 µm or less. When the distances C1 and C2 are 300 µm or less, the efficiency of attachment to the vapor deposition substrate 110 can be improved. The ranges of the distances C1 and C2 may be determined by using a first group consisting of 30 µm, 50 µm, 100 µm, and 150 µm and/or a second group consisting of 240 µm, 260 µm, 280 µm, and 300 µm. The ranges of the distances C1 and C2 may be determined by using a combination of a freely selected one of values in the first group described above and a freely selected one of values in the second group described above. The ranges of the distances C1 and C2 may be determined by using a combination of freely selected two of values in the first group described above. The ranges of the distances C1 and C2 may be determined by using a combination of freely selected two of values in the second group described above. For example, the ranges may be 30 µm or more and 300 µm or less, may be 30 µm or more and 280 µm or less, may be 30 µm or more and 260 µm or less, may be 30 µm or more and 240 µm or less, may be 30 µm or more and 150 µm or less, may be 30 µm or more and 100 µm or less, may be 30 µm or more and 50 µm or less, may be 50 µm or more and 300 µm or less, may be 50 µm or more and 280 µm or less, may be 50 µm or more and 260 µm or less, may be 50 µm or more and 240 µm or less, may be 50 µm or more and 150 µm or less, may be 50 µm or more and 100 µm or less, may be 100 µm or more and 300 µm or less, may be 100 µm or more and 280 µm or less, may be 100 µm or more and 260 µm or less, may be 100 µm or more and 240 µm or less, may be 100 µm or more and 150 µm or less, may be 150 µm or more and 300 µm or less, may be 150 µm or more and 280 µm or less, may be 150 µm or more and 260 µm or less, may be 150 µm or more and 240 µm or less, may be 240 µm or more and 300 µm or less, may be 240 µm or more and 280 µm or less, may be 240 µm or more and 260 µm or less, may be 260 µm or more and 300 µm or less, may be 260 µm or more and 280 µm or less, or may be 280 µm or more and 300 µm or less.

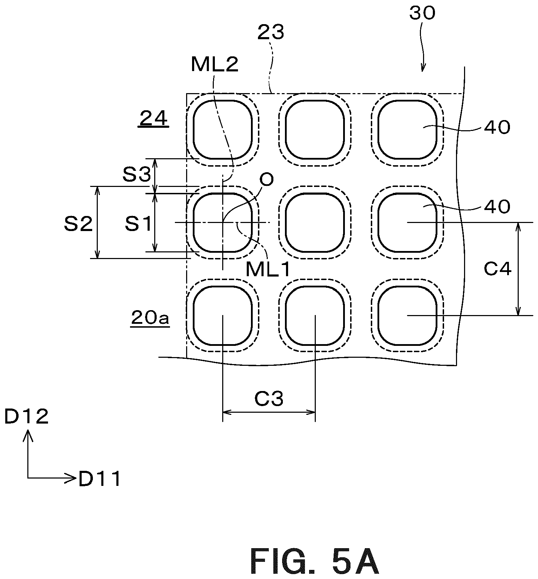

As for one of the through-hole groups 30, as illustrated in Fig. 4 and Fig. 5A, the multiple through-holes 40 may be arranged at a predetermined interval or a predetermined pitch. The through-holes 40 may be arranged at a predetermined pitch (reference characters C3 illustrated in Fig. 5A) in the first direction D11 and may be arranged at a predetermined pitch (reference characters C4 illustrated in Fig. 5A) in the second direction D12. The array pitches C3 and C4 of the through-holes 40 in the first direction D11 and the second direction D12 may differ from each other or may be equal to each other. In an example illustrated in Fig. 5A, the array pitch C3 in the first direction D11 is equal to the array pitch C4 in the second direction D12. As illustrated in Fig. 5A, the through-holes 40 may be arranged in parallel. That is, the through-holes 40 that are arranged in a row in the first direction D11 and the through-holes 40 that are arranged in another row adjacent to the row in the second direction D12 may be aligned in the second direction D12. The array pitches C3 and C4 of the through-holes 40 may be determined depending on the pixel density of a display device or a projecting device, for example, in the following manner.
· In the case where the pixel density is 600 ppi or more, the pitches are 42.3 µm or less.
· In the case where the pixel density is 1200 ppi or more, the pitches are 21.2 µm or less.
· In the case where the pixel density is 3000 ppi or more, the pitches are 8.5 µm or less.
· In the case where the pixel density is 5000 ppi or more, the pitches are 5.1 µm or less.
The display device or the projecting device that has a pixel density of 600 ppi may be used to display an image or a picture at a distance of about 15 cm from the eyeball and may be used for, for example, a smart phone. The display device or the projecting device that has a pixel density of 1200 ppi may be used to display an image or a picture at a distance of about 8 cm from the eyeball and may be used to display or project an image or a picture, for example, for expressing virtual reality (so-called VR). The display device or the projecting device that has a pixel density of 3000 ppi may be used to display an image or a picture at a distance of about 3 cm from the eyeball and may be used to display or project an image or a picture, for example, for expressing augmented reality (so-called AR). The display device or the projecting device that has a pixel density of 5000 ppi may be used to display an image or a picture at a distance of about 2 cm from the eyeball and may be used to display or project an image or a picture, for example, for expressing augmented reality.

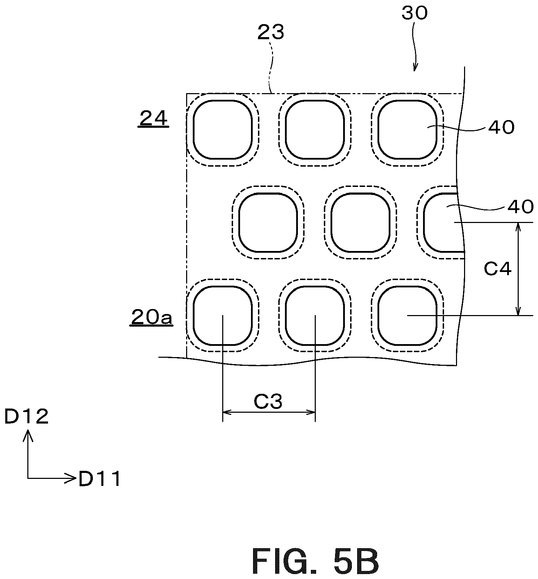

As for one of the through-hole groups 30, as illustrated in Fig. 5B, the through-holes 40 may be arranged in a staggered arrangement instead of parallel arrangement. That is, the through-holes 40 that are arranged in a row in the first direction D11 and the through-holes 40 that are arranged in another row adjacent to the row in the second direction D12 may be not aligned in the second direction D12. In an example illustrated in Fig. 5B, the through-holes 40 that are arranged in a row and the through-holes 40 that are arranged in another row adjacent to the row are shifted from each other in the first direction D11, and shifting amounts are half of the array pitch C3 in the first direction. The present disclosure, however, is not limited thereto, and the shifting amounts described above are not limited to half of the array pitch C3. In the example illustrated in Fig. 5B, two rows of the through-holes 40 adjacent to each other in the second direction D12 are shifted in the first direction D11, but two columns of the through-holes 40 adjacent to each other in the first direction D11 may be shifted in the second direction D12.

As illustrated in Fig. 5A, each through-hole 40 may have a contour that has a substantially rectangular shape in a plan view. In this case, four corners of the contour of each through-hole 40 may curve. The shape of the contour can be freely determined depending on the shapes of the pixels. Examples thereof may include another polygonal shape such as a hexagonal shape or an octagonal shape, and a circular shape. The shape of the contour may be a combination of multiple shapes. The contours of the through-holes 40 may have different shapes. The opening dimension of each through-hole 40 in the first direction D11 may be a dimension between two intersecting points at which a straight line (corresponding to a first intermediate straight line ML1 described later in Fig. 5A) that passes through the center O of the opening and that extends in the first direction D11 intersects with the contour of the opening. The opening dimension of each through-hole 40 in the second direction D12 may be a dimension between two intersecting points at which a straight line (corresponding to a second intermediate straight line ML2 described later in Fig. 5A) that passes through the center O of the opening and that extends in the second direction D12 intersects with the contour of the opening. The center O of the opening of each through-hole 40 at the first resin layer surface 21a and the second resin layer surface 21b may be an intersecting point of the first intermediate straight line ML1 and the second intermediate straight line ML2. The first intermediate straight line ML1 may be at the same distance from two straight lines that extend in the first direction D11 and that are circumscribed by the contour of the opening. The second intermediate straight line ML2 may be at the same distance from two straight lines that extend in the second direction D12 and that are circumscribed by the contour of the opening. In the case where each through-hole 40 has a contour that has a polygonal shape that has even numbered vertexes, as illustrated in Fig. 5A, the opening dimension of the through-hole 40 may be a distance between two facing sides of the polygonal shape.

In Fig. 5A, the opening dimension of one of the through-holes 40 at the first resin layer surface 21a is illustrated by using reference characters S1. The opening dimension of the through-hole 40 at the second resin layer surface 21b is illustrated by using reference characters S2. The opening dimension S2 is larger than the opening dimension S1. In Fig. 5A, the planar shape of the through-hole 40 is a square shape, and accordingly, the opening dimension of the through-hole 40 in the first direction D11 and the opening dimension of the through-hole 40 in the second direction D12 are equal to each other. The dimension of the through-hole 40 in the second direction D12 is representatively illustrated by using the reference characters S1 and S2. A reference character S3 represents a distance between the through-holes 40 adjacent to each other at the first resin layer surface 21a.

The dimension S1, the dimension S2, and the dimension S3 may be determined depending on the pixel density of the display device or the projecting device, for example, as illustrated in Table 1 below.

**[Table 1]**

| Pixel density | S1 | S2 | S3 |
|---|---|---|---|
| 600ppi | 14.0 µm or more and 28.0 µm or less | 14.0 µm or more and 40.0 µm or less | 14.0 µm or more and 28.0 µm or less |
| 1200ppi | 7.0 µm or more and 15.0 µm or less | 7.0 µm or more and 19.0 µm or less | 6.0 µm or more and 14.0 µm or less |
| 3000ppi | 3.0 µm or more and 6.0 µm or less | 3.0 µm or more and 7.0 µm or less | 2.5 µm or more and 5.5 µm or less |
| 5000ppi | 1.7 µm or more and 3.4 µm or less | 1.7 µm or more and 4.0 µm or less | 1.7 µm or more and 3.4 µm or less |

As illustrated in Fig. 3, the wall surfaces 41 of the through-holes 40 described above may be inclined at an angle θ1 with respect to the first resin layer surface 21a.

For example, the angle θ1 may be 60° or more, may be 65° or more, may be 70° or more, or may be 75° or more. When the angle θ1 is 60° or more, the array pitches C3 and C4 of the through-holes 40 can be reduced as described later. For example, the angle θ1 may be 80° or less, may be 83° or less, may be 85° or less, or may be 90° or less. When the angle θ1 is 90° or less, shadow can be inhibited from occurring. The range of the angle θ1 may be determined by using a first group consisting of 60°, 65°, 70°, and 75° and/or a second group consisting of 80°, 83°, 85°, and 90°. The range of the angle θ1 may be determined by using a combination of a freely selected one of values in the first group described above and a freely selected one of values in the second group described above. The range of the angle θ1 may be determined by using a combination of freely selected two of values in the first group described above. The range of the angle θ1 may be determined by using a combination of freely selected two of values in the second group described above. For example, the range may be 60° or more and 90° or less, may be 60° or more and 85° or less, may be 60° or more and 83° or less, may be 60° or more and 80° or less, may be 60° or more and 75° or less, may be 60° or more and 70° or less, may be 60° or more and 65° or less, may be 65° or more and 90° or less, may be 65° or more and 85° or less, may be 65° or more and 83° or less, may be 65° or more and 80° or less, may be 65° or more and 75° or less, may be 65° or more and 70° or less, may be 70° or more and 90° or less, may be 70° or more and 85° or less, may be 70° or more and 83° or less, may be 70° or more and 80° or less, may be 70° or more and 75° or less, may be 75° or more and 90° or less, may be 75° or more and 85° or less, may be 75° or more and 83° or less, may be 75° or more and 80° or less, may be 80° or more and 90° or less, may be 80° or more and 85° or less, may be 80° or more and 83° or less, may be 83° or more and 90° or less, may be 83° or more and 85° or less, or may be 85° or more and 90° or less.

The technical meaning of the angle θ1 will now be described. Components of a direction in which the vapor deposition material 82 comes at the vapor deposition step at which the vapor deposition material 82 is deposited on the vapor deposition substrate 110 by using the vapor deposition mask 10 will be described. In some cases, the components include a component when the vapor deposition material 82 comes in the thickness direction D2 of the vapor deposition mask 10 from the vapor deposition source (the crucible 81) toward the vapor deposition substrate 110 and a component when the vapor deposition material 82 comes in a direction inclining with respect to the thickness direction D2 of the vapor deposition mask 10, which depends on the structure of the crucible 81 illustrated in Fig. 1. In these cases, the vapor deposition material 82 that comes in the inclining direction is partly attached to the second resin layer surface 21b of the resin layer 21 and the wall surfaces 41 of the through-holes 40 before reaching the vapor deposition substrate 110. For this reason, the thickness of the vapor deposition layer (or the organic layers 130A, 130B, and 130C described later) that is formed on the vapor deposition substrate 110 is likely to reduce as the position is nearer to the wall surfaces 41 of the through-holes 40. This phenomenon is also referred to as shadow where the wall surfaces 41 of the through-holes 40 impede the attachment of the vapor deposition material 82 to the vapor deposition substrate 110. A conceivable measure for inhibiting shadow from occurring is to reduce the angle θ1 described above or to reduce the thickness H3 of the resin layer 21.

Reducing the angle θ1 means enlarging the openings of the through-holes 40 at the second resin layer surface 21b. In this case, the wall surfaces 41 of the through-holes 40 adjacent to each other at the second resin layer surface 21b are connected, and consequently, the second resin layer surface 21b is not present between the through-holes 40. That is, a material between the through-holes 40 adjacent to each other at the second resin layer surface 21b is removed by being irradiated with laser light at the through-hole formation step described later. For this reason, the angle θ1 may not be too small. In this case, the mechanical strength of the resin layer 21 can be ensured, and the array pitches C3 and C4 of the through-holes 40 can be reduced.

In the case where the angle θ1 is inhibited from being too small, the thickness H3 of the resin layer 21 may be reduced. Consequently, shadow can be inhibited from occurring. However, merely reducing the thickness H3 means reducing the mechanical strength of the resin layer 21. For this reason, the thickness H3 may not be excessively reduced. In this case, the mechanical strength of the resin layer 21 can be ensured.

In view of this, according to the present embodiment, the angle θ1 is relatively large, for example, 60° or more. The angle θ1 is larger than, for example, 50° or less in the case of an existing vapor deposition mask. For this reason, the wall surfaces 41 of the through-holes 40 can be formed in a shape nearly perpendicular to the first resin layer surface 21a and the second resin layer surface 21b of the resin layer 21, and the material of the resin layer 21 can remain near the through-holes 40. Accordingly, the mechanical strength of the resin layer 21 can be improved. Increasing the angle θ1 enables the array pitches C3 and C4 of the through-holes 40 to be reduced.

The angle θ1 of the vapor deposition mask 10 according to the present embodiment is thus 60° or more and 90° or less. For this reason, the vapor deposition mask 10 according to the present embodiment may be used for the vapor deposition apparatus 80 that includes the crucible 81 that has a vapor deposition angle (for example, 60° or more and 90° or less) of 90° or close to 90° or may be used for a vapor deposition apparatus (not illustrated) in a surface vapor deposition method. As for the vapor deposition apparatus 80 that includes the crucible 81 illustrated in Fig. 1, a component when the vapor deposition material 82 comes in a direction inclining with respect to the thickness direction D2 is included in some cases. As for the vapor deposition apparatus in the surface vapor deposition method, however, the vapor deposition source that is disposed below the vapor deposition substrate 110 has a planar spread so as to face the vapor deposition mask 10. This enables the vapor deposition material 82 to come in the thickness direction D2 to the vapor deposition substrate 110. For this reason, the vapor deposition material 82 can come evenly in the first direction D11 and in the second direction D12. The vapor deposition angle is 90° or close to 90°.

In some cases, one of the through-hole groups 30 is referred to as one of the effective regions 23. In some cases, a region around each effective region 23 is referred to as the surrounding region 24. In this case, the surrounding region 24 surrounds the multiple effective regions 23.

In the case where a display device such as the organic device 100 (described later) is manufactured by using the vapor deposition mask 10, one of the effective regions 23 corresponds to a display region of the single organic device 100. For this reason, the vapor deposition mask 10 illustrated in Fig. 2 enables the multiple organic devices 100 to be deposited on the single vapor deposition substrate 110. Such vapor deposition is also referred to as multi-attachment vapor deposition. In some cases, one of the effective regions 23 corresponds to display regions of the multiple organic devices 100.

As illustrated in, for example, Fig. 4, each effective region 23 may have a contour that has a substantially rectangular shape in a plan view. The contour of each effective region 23 may be defined by using a line that is circumscribed by the through-hole 40 that is located at the outermost position among the through-hole groups 30 that correspond thereto. More specifically, the contour of each effective region 23 may be defined by using a line that is in contact with the opening of the through-hole 40. In the example illustrated in Fig. 4, the through-holes 40 are arranged in parallel, and accordingly, the contour of each effective region 23 has a substantially rectangular shape. Each effective region 23 may have a contour that has a shape depending on the shape of the display region of each organic device 100 among various shapes. For example, each effective region 23 may have a contour that has a circular shape.

As illustrated in Fig. 2 and Fig. 3, first alignment marks 45 for adjusting the position of the vapor deposition substrate 110 may be provided on the mask substrate 15. The first alignment marks 45 can be located at freely determined positions, provided that the positions of the through-holes 40 of the vapor deposition mask 10 and the position of the vapor deposition substrate 110 can be adjusted. For example, as illustrated in Fig. 2 and Fig. 3, the first alignment marks 45 may be formed on the second substrate surface 15b of the mask substrate 15 at the substrate frame body 17. In the case where the vapor deposition substrate 110 has optical transparency that means properties that enable visible light to pass therethrough, the first alignment marks 45 that are provided on the mask substrate 15 can be visually recognized through the vapor deposition substrate 110, and the position of the vapor deposition substrate 110 and the positions of the through-holes 40 of the vapor deposition mask 10 can be easily adjusted. In the case where the vapor deposition substrate 110 does not have the optical transparency, for example, the first alignment marks 45 may be visually recognized by being irradiated with infrared rays via the vapor deposition substrate 110. In an example illustrated in Fig. 2, the planar shape of each first alignment mark 45 is a circular shape but is not limited thereto and may be a freely determined shape such as a rectangular shape or a cross shape. The first alignment marks 45 may be formed in a recessed shape by etching the second substrate surface 15b of the mask substrate 15 at the substrate etching step described later.

As illustrated in Fig. 3 and Fig. 4, second alignment marks 46 for adjusting the position of the vapor deposition substrate 110 may be provided on the first surface 20a of the mask layer 20. The second alignment marks 46 can be located at freely determined positions, provided that the positions of the through-holes 40 of the vapor deposition mask 10 and the position of the vapor deposition substrate 110 can be adjusted. For example, the second alignment marks 46 may be nearer than the first alignment marks 45 to the through-holes 40. For example, as illustrated in Fig. 3 and Fig. 4, the second alignment marks 46 may be formed on the first surface 20a of the mask layer 20 in the substrate opening 16 of the mask substrate 15 in a plan view. For example, the second alignment marks 46 may be located on the mask sash bars 28a and 28b that are formed between the through-hole groups 30 adjacent to each other. For example, the second alignment marks 46 may be located at the intersecting portions 29 at which the first mask sash bars 28a and the second mask sash bars 28b intersect with each other. In Fig. 4, the second alignment marks 46 are provided at the intersecting portions 29 at which the first mask sash bars 28a and the second mask sash bars 28b intersect with each other. In other words, the second alignment marks 46 are located on the first mask sash bars 28a, and the second alignment marks 46 are located on the second mask sash bars 28b. In this case, the second alignment marks 46 are located at positions that correspond to those of each corner portion of each through-hole group 30.

In the case where the vapor deposition substrate 110 has the optical transparency for visible light, the second alignment marks 46 that are provided on the mask layer 20 can be visually recognized through the vapor deposition substrate 110, and the position of the vapor deposition substrate 110 and the positions of the through-holes 40 of the vapor deposition mask 10 can be easily adjusted. In the case where the vapor deposition substrate 110 does not have the optical transparency, for example, the second alignment marks 46 may be visually recognized by being irradiated with infrared rays via the vapor deposition substrate 110. In the example illustrated in Fig. 4, the planar shape of each second alignment mark 46 is a circular shape but is not limited thereto and may be a freely determined shape such as a rectangular shape or a cross shape. The second alignment marks 46 may be formed in a recessed shape, for example, by irradiating the first resin layer surface 21a of the resin layer 21 with laser light.

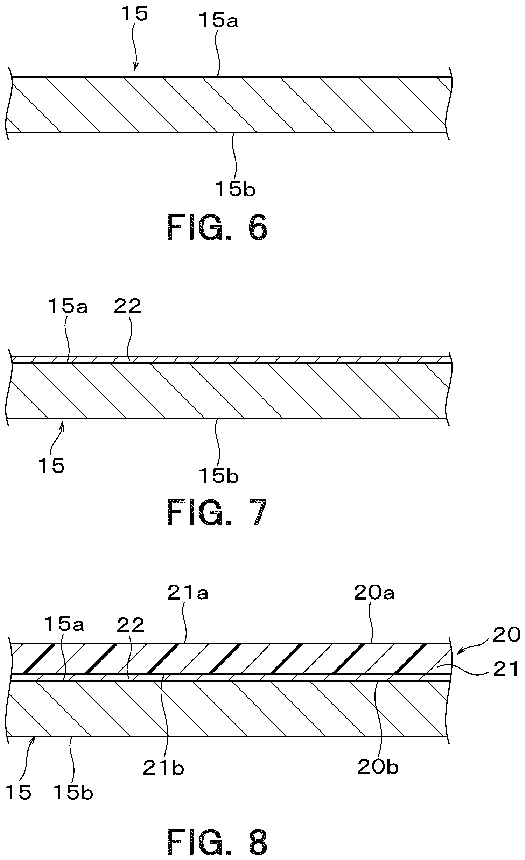

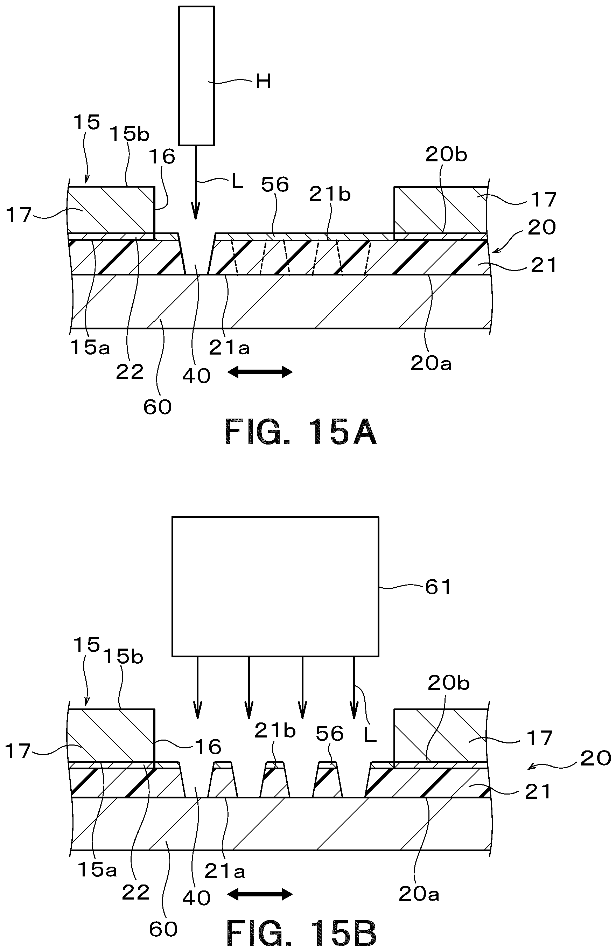

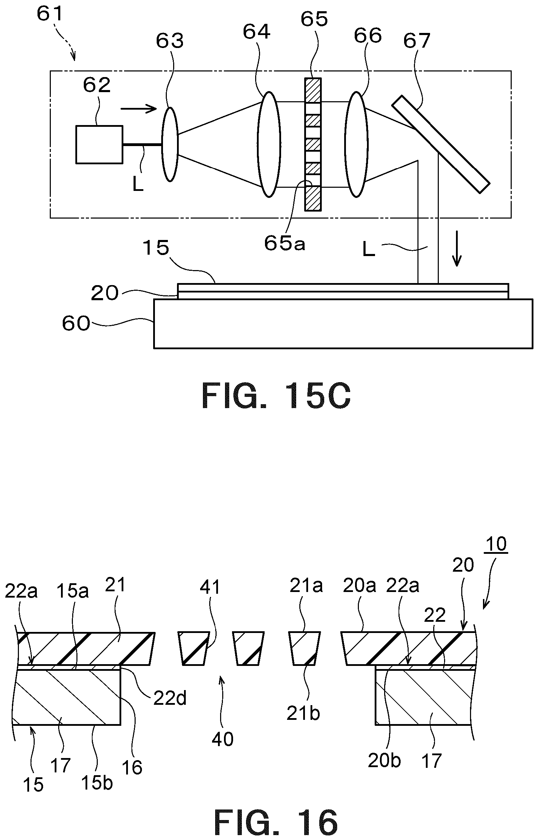

A method of manufacturing the vapor deposition mask 10 that is thus configured will now be described with reference to Fig. 6 to Fig. 16. In an example described herein, the mask substrate 15 is a silicon substrate. The method of manufacturing the vapor deposition mask 10 according to the present embodiment may include a substrate preparation step, a mask layer formation step, a mask protection layer formation step, a substrate opening formation step, a mask protection layer removal step, and a through-hole formation step. In Figs. 15 and Fig. 16, the number of the through-holes 40 is smaller than that in Fig. 3 to make the figure easy to understand.

At the substrate preparation step, as illustrated in Fig. 6, the mask substrate 15 that includes the first substrate surface 15a and the second substrate surface 15b may be prepared. For example, the mask substrate 15 may be a silicon wafer that has a plane orientation of (110) where the first substrate surface 15a and the second substrate surface 15b are polished mirror surfaces.

At the mask layer formation step after the substrate preparation step, the mask layer 20 that includes the first surface 20a and the second surface 20b may be formed on the mask substrate 15. The second surface 20b of the mask layer 20 faces the mask substrate 15 and is attached to the first substrate surface 15a of the mask substrate 15. At the mask layer formation step according to the present embodiment, a mask intermediate layer formation step of forming the mask intermediate layer 22 is first performed, and the resin layer formation step of forming the resin layer 21 is subsequently performed. The resin layer formation step is an example of a mask body layer formation step.

At the mask intermediate layer formation step, as illustrated in Fig. 7, the mask intermediate layer 22 is formed on the first substrate surface 15a of the mask substrate 15.

The mask intermediate layer 22 may be formed on the whole of the first substrate surface 15a of the mask substrate 15. The mask intermediate layer 22 may be formed, for example, by performing the sputtering process in which a spattering target composed of the material of the mask intermediate layer 22 is used. The mask intermediate layer 22 formed is attached to the mask substrate 15.

At the resin layer formation step, as illustrated in Fig. 8, the resin layer 21 may be formed on a surface of the mask intermediate layer 22 opposite the mask substrate 15. For example, a liquid resin material for forming the resin layer 21 is applied to the surface of the mask intermediate layer 22 opposite the mask substrate 15. The resin material may be applied by using, for example, a spin coater. Alternatively, the resin material may be applied by using, for example, a capillary coater. In this case, the thickness of the resin layer 21 can be uniform, and adhesion between the vapor deposition mask 10 and the vapor deposition substrate 110 can be improved. In the case where the resin material is applied by using the capillary coater, the resin material can be applied to a region of the mask intermediate layer 22 that is in contact with a die head such that the liquid resin material that is supplied to an end of the die head does not drop due to capillary action. The resin material may be heated, dried, and hardened after being applied. In this way, the resin layer 21 may be formed.

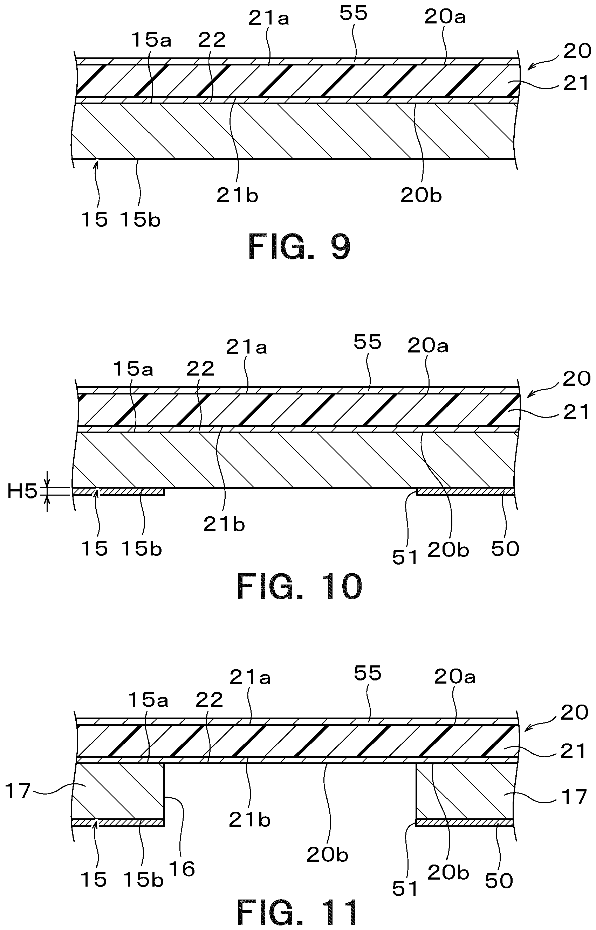

At the mask protection layer formation step after the mask layer formation step, as illustrated in Fig. 9, a mask protection layer 55 may be formed on the first resin layer surface 21a of the resin layer 21. The mask protection layer 55 may be formed on the whole of the first resin layer surface 21a of the resin layer 21. Examples of the mask protection layer 55 may be capable of reducing damage from, for example, a stage (not illustrated) on which the mask layer 20 is placed at the substrate etching step and may be capable of inhibiting a foreign substance from being attached to the resin layer 21. The thickness of the mask protection layer 55 may be equal to the thickness H4 of the mask intermediate layer 22. The material of the mask protection layer 55 may be the same as that of the mask intermediate layer 22. The mask protection layer 55 may be formed by performing the sputtering process as in the mask intermediate layer 22 described above.

At the substrate opening formation step after the mask protection layer formation step, the substrate opening 16 through which the second surface 20b of the mask layer 20 is exposed may be formed in the mask substrate 15. At the substrate opening formation step according to the present embodiment, a resist layer formation step, the substrate etching step, and a resist layer removal step are performed in this order. During this time period, the mask protection layer 55 is on the first resin layer surface 21a of the resin layer 21, and the resin layer 21 is protected from the etching medium for etching the mask substrate 15.

At the resist layer formation step, as illustrated in Fig. 10, a resist layer 50 is formed on the second substrate surface 15b of the mask substrate 15. The resist layer 50 includes a resist opening 51 that corresponds to the substrate opening 16. More specifically, liquid resist is first applied to the second substrate surface 15b of the mask substrate 15 by using a spinner, dried, and hardened, and consequently, the resist layer 50 is formed. The resist layer 50 may be formed on the whole of the second substrate surface 15b. Subsequently, the resist layer 50 is patterned by performing a photolithography process. For example, in the case where the resist layer 50 is negative resist, an exposure mask (not illustrated) is disposed on the resist layer 50 such that a portion of the resist layer 50 that corresponds to the resist opening 51 is not irradiated with light. Subsequently, the resist layer 50 is exposed to light via the exposure mask. The resist layer 50 exposed to light is developed, the portion of the resist layer 50 that is not exposed to light is removed, and the resist opening 51 is formed. After development, the resist layer 50 may be heated, and adhesion of the resist layer 50 to the mask substrate 15 may be improved. An example of the negative resist may be novolak resist. The resist layer 50 may be positive resist. Dry film resist that serves as the resist layer 50 may be stuck to the mask substrate 15.

For example, the thickness H5 of the resist layer 50 may be 0.1 µm or more, may be 0.5 µm or more, may be 1.0 µm or more, or may be 1.5 µm or more. When the thickness H5 is 0.1 µm or more, a portion that is covered by the resist layer 50 can be inhibited from being etched at the substrate etching step described later. For example, the thickness H5 may be 20.0 µm or less, may be 30.0 µm or less, may be 40.0 µm or less, or may be 50.0 µm or less. When the thickness H5 is 50.0 µm or less, availability can be ensured in the case of the dry film resist, and the resist layer 50 can be efficiently formed in the case of the liquid resist. The range of the thickness H5 may be determined by using a first group consisting of 0.1 µm, 0.5 µm, 1.0 µm, and 1.5 µm and/or a second group consisting of 20.0 µm, 30.0 µm, 40.0 µm, and 50.0 µm. The range of the thickness H5 may be determined by using a combination of a freely selected one of values in the first group described above and a freely selected one of values in the second group described above. The range of the thickness H5 may be determined by using a combination of freely selected two of values in the first group described above. The range of the thickness H5 may be determined by using a combination of freely selected two of values in the second group described above. For example, the range may be 0.1 µm or more and 50.0 µm or less, may be 0.1 µm or more and 40.0 µm or less, may be 0.1 µm or more and 30.0 µm or less, may be 0.1 µm or more and 20.0 µm or less, may be 0.1 µm or more and 1.5 µm or less, may be 0.1 µm or more and 1.0 µm or less, may be 0.1 µm or more and 0.5 µm or less, may be 0.5 µm or more and 50.0 µm or less, may be 0.5 µm or more and 40.0 µm or less, may be 0.5 µm or more and 30.0 µm or less, may be 0.5 µm or more and 20.0 µm or less, may be 0.5 µm or more and 1.5 µm or less, may be 0.5 µm or more and 1.0 µm or less, may be 1.0 µm or more and 50.0 µm or less, may be 1.0 µm or more and 40.0 µm or less, may be 1.0 µm or more and 30.0 µm or less, may be 1.0 µm or more and 20.0 µm or less, may be 1.0 µm or more and 1.5 µm or less, may be 1.5 µm or more and 50.0 µm or less, may be 1.5 µm or more and 40.0 µm or less, may be 1.5 µm or more and 30.0 µm or less, may be 1.5 µm or more and 20.0 µm or less, may be 20.0 µm or more and 50.0 µm or less, may be 20.0 µm or more and 40.0 µm or less, may be 20.0 µm or more and 30.0 µm or less, may be 30.0 µm or more and 50.0 µm or less, may be 30.0 µm or more and 40.0 µm or less, or may be 40.0 µm or more and 50.0 µm or less.

Alternatively, for example, the thickness H5 of the resist layer 50 may be 0.1 µm or more, may be 0.2 µm or more, may be 0.3 µm or more, or may be 0.4 µm or more. When the thickness H5 is 0.1 µm or more, the portion that is covered by the resist layer 50 can be inhibited from being etched at the substrate etching step described later. For example, H5 may be 0.6 µm or less, may be 0.7 µm or less, may be 0.8 µm or less, or may be 0.9 µm or less. When the thickness H5 is 0.9 µm or less, availability can be ensured with more certainty in the case of the dry film resist, and the resist layer 50 can be more efficiently formed in the case of the liquid resist. The range of H5 may be determined by using a first group consisting of 0.1 µm, 0.2 µm, 0.3 µm, and 0.4 µm and/or a second group consisting of 0.6 µm, 0.7 µm, 0.8 µm, and 0.9 µm. The range of H5 may be determined by using a combination of a freely selected one of values in the first group described above and a freely selected one of values in the second group described above. The range of H5 may be determined by using a combination of freely selected two of values in the first group described above. The range of H5 may be determined by using a combination of freely selected two of values in the second group described above. For example, the range may be 0.1 µm or more and 0.9 µm or less, may be 0.1 µm or more and 0.8 µm or less, may be 0.1 µm or more and 0.7 µm or less, may be 0.1 µm or more and 0.6 µm or less, may be 0.1 µm or more and 0.4 µm or less, may be 0.1 µm or more and 0.3 µm or less, may be 0.1 µm or more and 0.2 µm or less, may be 0.2 µm or more and 0.9 µm or less, may be 0.2 µm or more and 0.8 µm or less, may be 0.2 µm or more and 0.7 µm or less, may be 0.2 µm or more and 0.6 µm or less, may be 0.2 µm or more and 0.4 µm or less, may be 0.2 µm or more and 0.3 µm or less, may be 0.3 µm or more and 0.9 µm or less, may be 0.3 µm or more and 0.8 µm or less, may be 0.3 µm or more and 0.7 µm or less, may be 0.3 µm or more and 0.6 µm or less, may be 0.3 µm or more and 0.4 µm or less, may be 0.4 µm or more and 0.9 µm or less, may be 0.4 µm or more and 0.8 µm or less, may be 0.4 µm or more and 0.7 µm or less, may be 0.4 µm or more and 0.6 µm or less, may be 0.6 µm or more and 0.9 µm or less, may be 0.6 µm or more and 0.8 µm or less, may be 0.6 µm or more and 0.7 µm or less, may be 0.7 µm or more and 0.9 µm or less, may be 0.7 µm or more and 0.8 µm or less, or may be 0.8 µm or more and 0.9 µm or less.

At the substrate etching step, as illustrated in Fig. 11, the mask substrate 15 is etched through the resist opening 51, and the substrate opening 16 is formed. Consequently, a portion of the second surface 20b of the mask layer 20 is exposed through the substrate opening 16. The process of etching the mask substrate 15 may be a dry etching process in which etching gas is used. The etching gas is an example of the etching medium. In this case, the mask substrate 15 may be etched by using, for example, the etching gas such as DEEP-RIE, ICP (Inductively Coupled Plasma), SF6 gas, CF gas, or chlorine gas. In the case where the dry etching process is performed, an etching speed can be increased, and the wall surface of the substrate opening 16 can be substantially perpendicular to the first substrate surface 15a. The mask intermediate layer 22 that is composed of a material that enables the erosion of the etching medium to be reduced functions as a stopper layer that stops etching. The mask substrate 15 may be etched by performing a wet etching process in which an etching solution is used. The etching solution is an example of the etching medium. For example, a 35 weight% of potassium hydroxide aqueous solution at 80°C may be used as the etching solution, and the mask substrate 15 may be immersed in the etching solution for a predetermined time. The portion of the mask substrate 15 that is exposed from the resist layer 50 may be etched by anisotropic etching so as to depend on the plane orientation (or a crystal orientation).

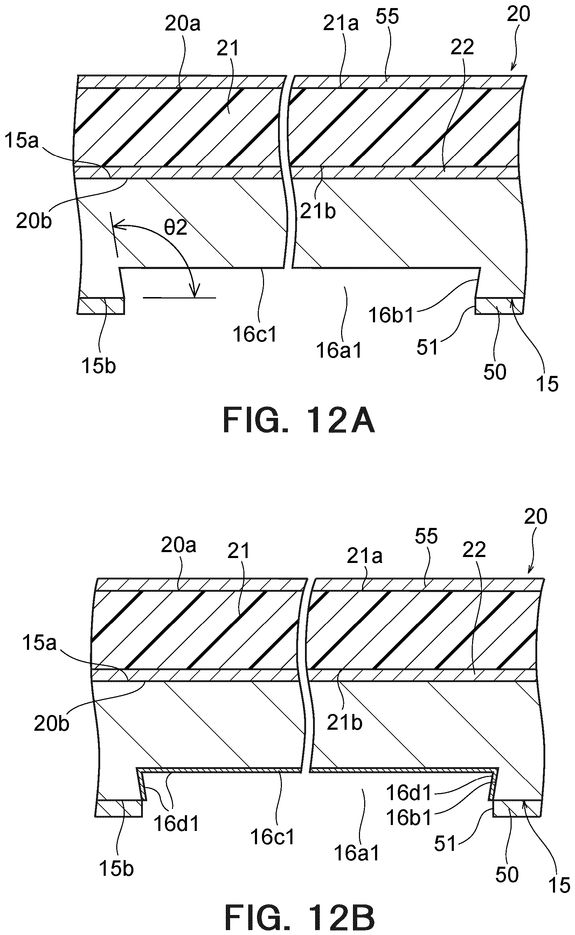

The substrate etching step will be described in more detail. In an example described herein with reference to Fig. 12A to Fig. 12E, the substrate opening 16 illustrated in Fig. 3 is formed by so-called deep RIE (deep reactive-ion etching). Fig. 12A to Fig. 12E schematically illustrate an enlarged sectional view of a portion of the substrate opening 16 illustrated in Fig. 3.

As illustrated in Fig. 12A, a portion of the resist layer 50 that is exposed through the resist opening 51 is etched by anisotropic etching. Consequently, a first recessed portion 16a1 is formed on the second substrate surface 15b. The first recessed portion 16a1 includes a wall surface 16b1 that extends from the resist opening 51 toward the first substrate surface 15a and an end surface 16c1. The wall surface 16b1 is formed so as to spread toward the first substrate surface 15a. That is, as illustrated in Fig. 12A, an angle θ2 that is formed between the wall surface 16b1 and the first substrate surface 15a is slightly larger than 90°.

As for anisotropic dry etching, the plasma of gas for etching is generated in a vapor deposition chamber (not illustrated) in which the mask substrate 15 is disposed, and the second substrate surface 15b of the mask substrate 15 is irradiated with the plasma. The etching gas for generating the plasma may be the etching gas described above. Etching not only progresses in the thickness direction of the mask substrate 15 but also slightly progresses in the direction of the second substrate surface 15b. However, reducing etching time enables etching in the direction of the second substrate surface 15b to be inhibited from progressing.

After the first recessed portion 16a1 is formed, as illustrated in Fig. 12B, a first protection layer 16d1 is formed on the wall surface 16b1 and the end surface 16c1 of the first recessed portion 16a1. The first protection layer 16d1 is formed on the wall surface 16b1 and the end surface 16c1 by supplying material gas such as C₄F₈ gas to the first recessed portion 16a1.

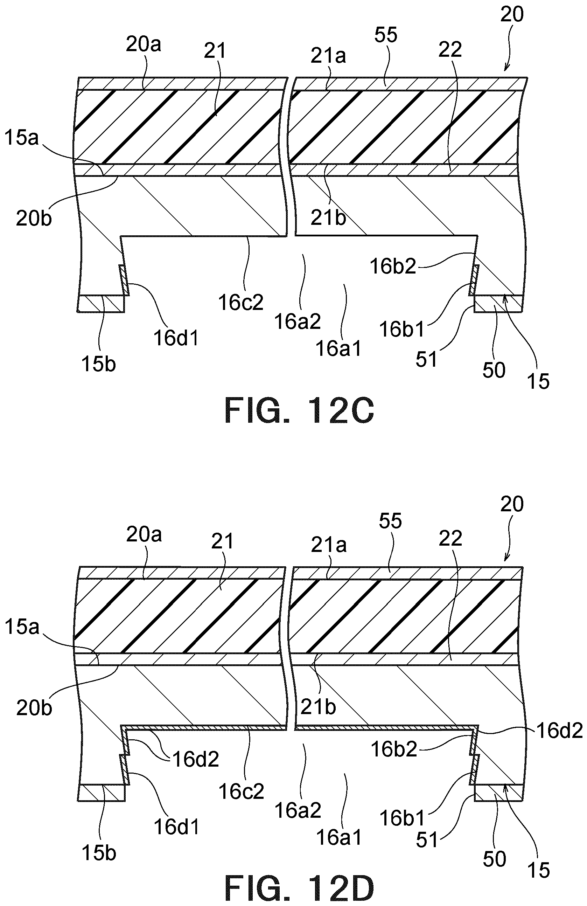

After the first protection layer 16d1 is formed, as illustrated in Fig. 12C, the first recessed portion 16a1 is etched by anisotropic dry etching. Consequently, a portion of the first protection layer 16d1 that is located at the end surface 16c1 is removed, and a second recessed portion 16a2 is formed. More specifically, the end surface 16c1 of the first recessed portion 16a1 is etched by anisotropic dry etching in the same manner as in that at a step of forming the first recessed portion 16a1, and the second recessed portion 16a2 that is connected to the first recessed portion 16a1 is formed. At this time, a wall surface 16b2 of the second recessed portion 16a2 is formed so as to spread toward the first substrate surface 15a as in the wall surface 16b1 of the first recessed portion 16a1 described above.

The first protection layer 16d1 that is formed on the wall surface 16b1 of the first recessed portion 16a1 may be removed by anisotropic dry etching for forming the second recessed portion 16a2 or may not be removed. Even in the case where the first protection layer 16d1 is removed, the wall surface 16b1 of the first recessed portion 16a1 can be inhibited from being eroded due to etching until the first protection layer 16d1 is removed. In the case where the first protection layer 16d1 is not removed but remains, the wall surface 16b of the first recessed portion 16a1 can be further inhibited from being eroded due to etching. Even in the case where the first protection layer 16d1 is not removed, the first protection layer 16d1 may be partly removed by etching.

As illustrated in Fig. 12D, a second protection layer 16d2 is formed on the wall surface 16b2 and an end surface 16c2 of the second recessed portion 16a2. The second protection layer 16d2 can be formed in the same manner as in the first protection layer 16d1.

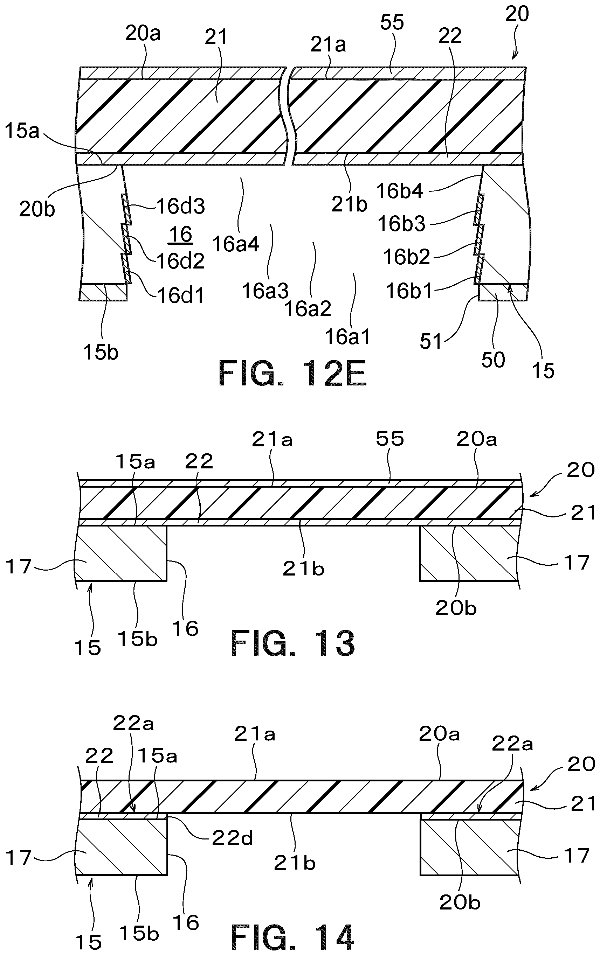

As illustrated in Fig. 12E, the formation of the recessed portions and the formation of the protection layers are repeated multiple times until the mask substrate 15 is etched up to the mask intermediate layer 22. In an example illustrated in Fig. 12E, a third recessed portion 16a3 that includes a wall surface 16b3 and a fourth recessed portion 16a4 that includes a wall surface 16b4 are formed after the second recessed portion 16a2 to simplify the description. The fourth recessed portion 16a4 extends to the mask intermediate layer 22 that functions as the stopper layer for etching. The mask intermediate layer 22 according to the present embodiment is composed of a material that enables the erosion of the etching gas to be reduced. For this reason, the mask intermediate layer 22 is capable of functioning the stopper layer for etching and is not etched but remains. A third protection layer 16d3 is formed on the wall surface 16b3, but no protection layer is formed on the wall surface 16b4.

Subsequently, the protection layers 16d1 to 16d3 that remain on the wall surfaces 16b1 to 16b3 of the recessed portions 16a1 to 16a3 are removed by using a process liquid. An example of the process liquid may be hydrofluoroether (HFE). For example, the protection layers 16d1 to 16d3 may be immersed in a process liquid at a temperature of a normal temperature (for example, about 25°C) to 70°C for 30 minutes. As for the process liquid, an undiluted solution that is not diluted may be used.

In this way, the substrate opening 16 illustrated in Fig. 11 is formed on the mask substrate 15. The wall surface of the substrate opening 16 is formed by the wall surfaces 16b1 to 16b4 of the recessed portions 16a1 to 16a4. The time of dry etching for forming the recessed portions 16a1 to 16a4 may be reduced, and the number of times the formation of the recessed portions 16a1 to 16a4 and the formation of the protection films are repeated may be increased. In this case, the wall surface of the substrate opening 16 that is formed by the wall surfaces 16b1 to 16b4 of the recessed portions 16a1 to 16a4 can be substantially perpendicular to the second substrate surface 15b. The wall surfaces 16b1 to 16b4 of the recessed portions 16a1 to 16a4 adjacent to each other can have fine steps, but reducing the thicknesses of the protection layer 16d1 to 16d3 described above enables the steps to be small. In this case, the wall surface of the substrate opening 16 can be formed so as to form a straight line substantially perpendicular to the first substrate surface 15a in a section illustrated in Fig. 11.

At the substrate etching step, a step of forming the first alignment marks 45 illustrated in Fig. 2 and Fig. 3 may be performed. That is, at the substrate etching step, the first alignment marks 45 may be formed.

At the resist layer removal step, as illustrated in Fig. 13, the resist layer 50 is removed from the mask substrate 15. For example, the resist layer 50 may be removed from the mask substrate 15 by using an alkali stripping solution.

At the mask layer opening formation step and the mask protection layer removal step after the substrate opening formation step, as illustrated in Fig. 14, the mask layer opening 22d is formed, and the mask protection layer 55 is removed. For example, a portion of the mask intermediate layer 22 that is located in the substrate opening 16 in a plan view may be removed by etching. This enables the mask layer opening 22d to be formed. The mask protection layer 55 may be removed by etching. The whole of the mask protection layer 55 may be removed from the first resin layer surface 21a of the resin layer 21. An example of an etching solution that is used at the mask layer opening formation step may be a mixed acid aluminum etching solution. For example, the mask intermediate layer 22 and the mask protection layer 55 may be immersed in the mixed acid aluminum etching solution at the normal temperature. For example, in the case where the thicknesses of the mask intermediate layer 22 and the mask protection layer 55 are 100 nm, the mask intermediate layer 22 and the mask protection layer 55 may be immersed in the mixed acid aluminum etching solution for two minutes. The mixed acid aluminum etching solution may be an undiluted solution that is not diluted.

In this way, as illustrated in Fig. 14, the mask substrate 15 that includes the substrate opening 16 is obtained.

The substrate opening formation step is not limited to the step described above. For example, at the substrate opening formation step, a resistance layer (not illustrated) such as a silicon oxide layer, a silicon nitride layer, or a silicon carbide layer may be formed on the second substrate surface 15b of the mask substrate 15. In this case, a resistance layer opening may be formed in the resistance layer, and subsequently, the mask substrate 15 may be etched through the resistance layer opening. The resistance layer opening may be formed in a manner in which a resist layer that includes a resist opening is formed on the resistance layer by performing the photolithography process, and the resistance layer is etched through the resist opening. The mask substrate 15 may be etched through the resistance layer opening, and the substrate opening 16 may be formed. After the substrate opening 16 is formed, the resistance layer may be removed.

The mask layer opening formation step and the mask protection layer removal step may not be simultaneously performed but may be separately performed.

At the through-hole formation step after the mask layer opening formation step and the mask protection layer removal step, the multiple through-holes 40 may be formed in the resin layer 21 so as to be exposed to the substrate opening 16. The through-holes 40 may be formed in a manner in which the resin layer 21 is irradiated with laser light L. The through-holes 40 may be formed so as to extend through the first resin layer 21.

For example, as illustrated in Fig. 15A, the through-holes 40 may be formed one by one by emitting the laser light L.

More specifically, as illustrated in Fig. 15A, the mask substrate 15 and the mask layer 20 that are obtained as described above are first placed on a movable stage 60.

Subsequently, the formation of the through-holes 40 and the movement of the movable stage 60 are repeated, and consequently, a large number of the through-holes 40 may be formed. In this case, an irradiation head H may not be moved.

For example, the irradiation head H is caused to face a position (the center of each through-hole 40) at which each through-hole 40 is to be formed. Subsequently, the second resin layer surface 21b of the resin layer 21 is irradiated with the laser light L via the substrate opening 16 in a direction from the mask substrate 15 toward the resin layer 21. Consequently, the material of a portion of the resin layer 21 that is irradiated with the laser light L is sublimated and removed, and as illustrated in Fig. 15A, the through-holes 40 are formed. In this case, the wall surfaces 41 of the through-holes 40 tend to be formed so as to be perpendicular to the second resin layer surface 21b. As illustrated in Fig. 15A, however, the wall surfaces 41 of the through-holes 40 can be inclined depending on the strength and pulse width of the laser light L and the thickness of the resin layer 21.

The laser light L with which the resin layer 21 is irradiated may be YAG laser light. The YAG laser light may use YAG crystal into which neodymium is added. The YAG laser light may be laser light of xenon long arc flash lamp excitation. For example, the output of the YAG laser light L may be 200 mJ. Pulse width may be 20 ns or less. A wavelength may be 355 nm. Oscillation frequency may be 60 Hz. The number of times the laser light L is emitted to form the one of the through-holes 40 may be one or multiple times to form the one of the through-holes 40. For example, the number may be 40 times.

After the one of the through-holes 40 is formed, the emission of the laser light L is stopped. The movable stage 60 is moved, and the irradiation head H is subsequently caused to face a next position (the center of the through-hole 40) at which the through-hole 40 is to be formed. The laser light L is emitted in the same manner as above. These are repeated, and consequently, a large number of the through-holes 40 are formed in the vapor deposition mask 10 according to the present embodiment.

In the case where the laser light L is emitted, and the through-holes 40 are formed as described above, the movable stage 60 may not be moved, but the irradiation head H may be moved.

In the case where the through-holes 40 are formed by using the laser light L, as illustrated in Fig. 15A, a sticky layer 56 may be attached to a portion of the second resin layer surface 21b of the resin layer 21 that is exposed to the substrate opening 16. This enables the precision of the shapes and the precision of the positions of the through-holes 40 to be improved and enables a burr to be inhibited from being formed on the second resin layer surface 21b. In this case, the material of the sticky layer 56 is not particularly limited. An example of the sticky layer 56 may be FIXFILM HG1-50 made by FUJICOPIAN CO., LTD.

A method of forming the through-holes 40 is not limited thereto. For example, as illustrated in Fig. 15B, the multiple through-holes 40 may be formed in parallel by emitting the laser light L. For example, as illustrated in Fig. 15B and Fig. 15C, the laser light L may be emitted from a laser light generation device 61.

The laser light generation device 61 illustrated in Fig. 15C includes a laser light source 62, a first lens 63, a second lens 64 (also referred to as a collimator lens), a photo mask 65, a third lens 66 (also referred to as a condensing lens), and a mirror 67. The laser light L that is emitted from the laser light source 62 is enlarged by the first lens 63 and becomes parallel light through the second lens 64. The laser light L that becomes the parallel light passes through mask holes 65a of the photo mask 65 and is focused by the third lens 66. The laser light L focused is reflected by the mirror 67, changes the direction, and is emitted to the second resin layer surface 21b of the resin layer 21. The laser light L that passes through the photo mask 65 and the third lens 66 is patterned light so as to correspond to the through-holes 40 as illustrated in Fig. 15B although this is simplified in Fig. 15C.

The photo mask 65 includes the multiple mask holes 65a at positions that correspond to those of the multiple through-holes 40. In an example illustrated in Fig. 15B, the laser light L that passes through one of the mask holes 65a forms a corresponding one of the through-holes 40. In this case, one of the mask holes 65a may be assigned to one of the through-holes 40. The photo mask 65 may include a substrate that has the optical transparency such as glass and a layer that is obtained by forming a patterned metal material such as chromium on the substrate and that includes the mask holes 65a described above. In Fig. 15C, the substrate described above is omitted to simplify the figure.

Subsequently, the movable stage 60 may be moved, and the position to which the laser light L is emitted may be adjusted. In the case where the laser light generation device 61 is movable, the laser light generation device 61 may be moved.

Subsequently, the second resin layer surface 21b of the resin layer 21 is irradiated with the laser light L from the laser light generation device 61. Consequently, the materials of multiple portions of the resin layer 21 that are irradiated with the laser light L are sublimated and removed, and as illustrated in Fig. 15B, the multiple through-holes 40 are formed in parallel. The laser light L that passes through a corresponding one of the mask holes 65a assigned forms each through-hole 40. The number of times the laser light L is emitted to form the through-holes 40 may be one or multiple times to form the through-holes 40. The photo mask 65 is not limited by the case where the multiple through-holes 40 are formed in parallel but may be used in the case where the laser light L passes through one of the mask holes 65a, and the through-holes 40 are formed one by one. In this case, the through-holes 40 are formed one by one by emitting the laser light L.

The multiple mask holes 65a may be assigned to one of the through-holes 40. In this case, the mask hole(s) 65a that has(have) a relatively large planar shape may be located at the center of the through-hole 40. In addition, the mask holes 65a that have a relatively small planar shape may be located in the vicinity of the mask hole(s) 65a that has(have) a relatively large planar shape. The sizes of the planar shapes of the mask holes 65a may be gradually reduced in an outward direction from the center of the through-hole 40. In some cases, the pattern of the mask holes 65a is referred to as a halftone pattern or a gradation pattern. That is, the mask hole(s) 65a that has(have) a relatively large planar shape may be assigned to the center of the through-hole 40, and the mask holes 65a that have a relatively small planar shape may be assigned to the vicinity of the mask hole(s) 65a that has(have) a relatively large planar shape. In this case, the laser light L that passes through the mask hole(s) 65a that is(are) large at the center is emitted to the resin layer 21 with relatively high intensity. For this reason, the laser light L that passes through the mask hole(s) 65a that has(have) a relatively large planar shape enables the hole that extends through the resin layer 21 to be formed. The laser light L that passes through the mask holes 65a that are relatively small in the vicinity is emitted to the resin layer 21 with relatively low intensity. For this reason, no holes extend through the resin layer 21 at the positions to which the laser light L that passes through the mask holes 65a that have a relatively small planar shape is emitted, and the material in a recessed shape is removed. The sizes of the planar shapes of the mask holes 65a that are assigned to the one of the through-holes 40 is gradually reduced in the outward direction from the center, and consequently, the multiple through-holes 40 the wall surfaces 41 of which are inclined can be formed in parallel as illustrated in Fig. 3.

In the example illustrated in Fig. 15B, the multiple through-holes 40 are formed in parallel by emitting the laser light L by using the photo mask 65. The present disclosure, however, is not limited thereto, and the through-holes 40 may be formed one by one by emitting the laser light L via the multiple mask holes 65a of the photo mask 65. That is, in the case where the multiple mask holes 65a are assigned to one of the through-holes 40, the laser light L may be emitted to only the mask holes 65a. In this case, the through-holes 40 that include the wall surfaces 41 that are inclined can be formed one by one.

At the through-hole formation step, a step of forming the second alignment marks 46 illustrated in Fig. 3 and Fig. 4 may be performed. That is, the vapor deposition mask 10 is reversed in the up-down direction such that the first resin layer surface 21a faces the irradiation head H. The first resin layer surface 21a may be irradiated with the laser light, and the second alignment marks 46 that have a recessed shape may be formed.

In this way, the vapor deposition mask 10 according to the present embodiment illustrated in Fig. 16 is obtained.

A method of manufacturing an organic EL display device by using the vapor deposition mask 10 according to the present embodiment will now be described with reference to Fig. 1, Fig. 17A, and Fig. 17B.

The components and display region of the organic device 100 will be described in detail. Fig. 17A illustrates a plan view of an example of the organic device 100 and illustrates the organic layers that are deposited at the vapor deposition step. Fig. 17B illustrates a sectional view of the organic device 100 in Fig. 17A taken along a line B-B. Fig. 17A illustrates a plan view of the organic layers that are deposited at the vapor deposition step where second electrodes 140 that are formed after the vapor deposition step and that will be described later are omitted. An example of the organic device 100 is an organic EL display device. The organic device 100 includes a light-emitting layer that is formed on the vapor deposition substrate 110 described later by using the vapor deposition mask 10 described above according to the present embodiment. The single organic device 100 may correspond to the single display region.

As illustrated in Fig. 17A and Fig. 17B, the organic device 100 includes the vapor deposition substrate 110 and elements 115 that are located on the vapor deposition substrate 110. The elements 115 may include first electrodes 120, organic layers 130 that are located on the first electrodes 120, and the second electrodes 140 that are located on the organic layers 130.

The organic device 100 may include an insulating layer 160 that is located between two first electrodes 120 adjacent to each other in a plan view. The insulating layer 160 may contain, for example, polyimide. The insulating layer 160 may overlap end portions of the first electrodes 120.

The organic device 100 may be an active-matrix device. For example, the organic device 100 may include switches that are electrically connected to the respective multiple elements 115 although this is not illustrated. Examples of the switches may include transistors. The switches are capable of controlling on-off of a voltage or current to the respective elements 115.

The vapor deposition substrate 110 may include a first surface 110a on which the first electrodes 120 are formed and a second surface 110b that is located opposite the first surface 110a. The vapor deposition substrate 110 may be an insulating plate member. The vapor deposition substrate 110 may have the optical transparency such that light passes therethrough.

In the case where the vapor deposition substrate 110 has predetermined optical transparency, the optical transparency of the vapor deposition substrate 110 may be such that light from the organic layers 130 can pass therethrough and can be displayed. For example, the transmittance of the vapor deposition substrate 110 in a visible-light region may be 80% or more or may be 90% or more. The transmittance of the vapor deposition substrate 110 can be measured by using a Plastics-Determination of the total luminous transmittance of transparent materials based on JIS K7361-1.

The vapor deposition substrate 110 may be flexible or may not be flexible. The vapor deposition substrate 110 can be appropriately selected depending on the use of the organic device 100.

For example, the vapor deposition substrate 110 contains silicon, and examples may include a silicon substrate. Alternatively, the vapor deposition substrate 110 may contain glass, and the examples may include a glass substrate. The examples of the material of the vapor deposition substrate 110 may also include rigid materials that are not flexible such as quartz glass, Pyrex (registered trademark) glass, and a synthetic quartz plate. Alternatively, the material of the vapor deposition substrate 110 may include flexible materials such as a resin film (such as a polyimide film or a liquid-crystal polymer), an optical resin plate, and thin glass. The vapor deposition substrate 110 may be a stacked body that includes a barrier layer on a surface of a resin film or barrier layers on both surfaces of the resin film.

In the case where the vapor deposition substrate 110 is composed of a material other than a silicon substrate, the thickness of the vapor deposition substrate 110 may be appropriately selected depending on, for example, the material used for the vapor deposition substrate 110 or the use of the organic device 100. In this case, for example, the thickness of the vapor deposition substrate 110 may be 0.005 mm or more. The thickness of the vapor deposition substrate 110 may be 5 mm or less.

The elements 115 are configured to fulfill a function in a manner in which a voltage is applied between the first electrodes 120 and the second electrodes 140 or a current flows between the first electrodes 120 and the second electrodes 140. For example, in the case where the elements 115 are pixels of an organic EL display device, the elements 115 are capable of emitting light for forming a picture.

The first electrodes 120 contain a conductive material. For example, the first electrodes 120 contain metal, a conductive metal oxide or another conductive inorganic material. The first electrodes 120 may contain a conductive metal oxide that has the optical transparency such as an indium tin oxide.

An example of the material of the first electrodes 120 may be metal such as Au, Cr, Mo, Ag, or Mg. Alternatively, the material of the first electrodes 120 may be an indium tin oxide abbreviated as ITO, an indium zinc oxide abbreviated as IZO, or an inorganic oxide such as a zinc oxide or an indium oxide. Alternatively, an example of the material of the first electrodes 120 may be a conductive polymer such as polythiophene doped with metal. These conductive materials may be used alone, or two or more kinds of the materials may be combined and used. In the case where two or more kinds of the materials are used, layers composed of the respective materials may be stacked on the conductive material. The conductive material may be an alloy that contains two or more kinds of the materials. For example, the conductive material may be a magnesium alloy such as MgAg.

The organic layers 130 contain an organic material. When the organic layers 130 are energized, the organic layers 130 can perform a function. The phrase "to be energized" means that a voltage is applied to the organic layers 130, or a current flows through the organic layers 130. Examples of the organic layers 130 may include light-emitting layers that emit light when being energized and layers the refractive index or the optical transmittance of which changes when being energized. The organic layers 130 may contain an organic semiconductor material.

As illustrated in Fig. 17B, the organic layers 130 may include the first organic layers 130A and the second organic layers 130B. As illustrated in Fig. 17A, the organic layers 130 may further include the third organic layers 130C. For example, the first organic layers 130A, the second organic layers 130B, and the third organic layers 130C are red light-emitting layers, blue light-emitting layers, and green light-emitting layers. In the following description, the words and reference characters of the "organic layers 130" are used in the case of description of a structure that is common to the first organic layers 130A, the second organic layers 130B, and the third organic layers 130C among structures in the organic layers.

Stacked structures that include the first electrodes 120, the first organic layers 130A, and the second electrodes 140 are also referred to as first elements 115A. Stacked structures that include the first electrodes 120, the second organic layers 130B, and the second electrodes 140 are also referred to as second elements 115B. Stacked structures that include the first electrodes 120, the third organic layers 130C, and the second electrodes 140 are also referred to as third elements 115C. In the case where the organic device 100 is an organic EL display device, the first elements 115A, the second elements 115B, and the third elements 115C are sub-pixels.

In the following description, the words and reference characters of the "elements 115" are used in the case of description of a structure that is common to the first elements 115A, the second elements 115B, and the third elements 115C among structures in the elements. In a plan view such as Fig. 17A, the contours of the elements 115 may be the same as the contours of the organic layers 130 that overlap the first electrodes 120 and the second electrodes 140 in a plan view. In the case where the organic device 100 includes the insulating layers 160, the contours of the elements 115 may be the same as the contours of the organic layers 130 that overlap the first electrodes 120 and the second electrodes 140 and that do not overlap the insulating layers 160 in a plan view.

The arrays of the first elements 115A, the second elements 115B, and the third elements 115C will be described. As illustrated in Fig. 17A, the first elements 115A, the second elements 115B, and the third elements 115C may be arranged in an element first direction F1. The first elements 115A, the second elements 115B, and the third elements 115C may be arranged in an element second direction F2.

When a voltage is applied between the first electrodes 120 and the second electrodes 140, the organic layers 130 that are located therebetween are driven. In the case where the organic layers 130 are light-emitting layers, light is emitted from the organic layers 130, and the light exits from the second electrodes 140 or the first electrodes 120 to the outside.

In the case where the organic layers 130 include light-emitting layers that emit light when being energized, the organic layers 130 may further include a hole injection layer, a hole transport layer, an electron transport layer, an electron injection layer, and another layer.

For example, in the case where the first electrodes 120 are anodes, the organic layers 130 may include hole injection transport layers between light-emitting layers and the first electrodes 120. The hole injection transport layers may be hole injection layers that have a hole injection function, may be hole transport layers that have a hole transport function, or may have both of the hole injection function and the hole transport function. The hole injection transport layers may have a structure in which a hole injection layer and a hole transport layer are stacked.

In the case where the second electrodes 140 are cathodes, the organic layers 130 may include electron injection transport layers between light-emitting layers and the second electrodes 140. The electron injection transport layers may be electron injection layers that have an electron injection function, may be electron transport layers that have an electron transport function, or may have both of the electron injection function and the electron transport function. The electron injection transport layers may have a structure in which an electron injection layer and an electron transport layer are stacked.

The light-emitting layers contain a light-emitting material. The light-emitting layers may contain an additive that improves leveling properties.

A known material may be used as the light-emitting material, and examples of the light-emitting material may include a pigment material, a metal complex material, or a polymeric material.

The film thicknesses of the light-emitting layers are not particularly limited provided that the film thicknesses enable an electron and a hole to be recombined and enables light to be emitted. For example, the film thicknesses of the light-emitting layers may be 1 nm or more. The film thicknesses of the light-emitting layers may be 500 nm or less.

The second electrodes 140 contain a conductive material such as metal. The second electrodes 140 are formed on the organic layers 130 by performing the vapor deposition method in which a mask described later is used. Examples of the material of the second electrodes 140 may include platinum, gold, silver, copper, iron, tin, chromium, aluminum, indium, lithium, sodium, potassium, calcium, magnesium, chromium, or carbon. These conductive materials may be used alone, or two or more kinds of the materials may be combined and used. In the case where two or more kinds of the materials are used, layers composed of the respective materials may be stacked on the conductive material. An alloy that contains two or more kinds of the materials may be used as the conductive material. For example, the conductive material may be a magnesium alloy such as MgAg, an aluminum alloy such as AlLi, AlCa, or AlMg, an alkali metal alloy, or an alkali earth metal alloy.

As illustrated in Fig. 17B, the organic device 100 may include a sealing layer (not illustrated) that covers elements on the vapor deposition substrate 110 such as the organic layers 130A, 130B, and 130C. The sealing layer is capable of inhibiting, for example, water vapor outside the organic device 100 from entering the organic device 100. This enables the organic layers 130A, 130B, and 130C, for example, to be inhibited from being degraded due to moisture. The sealing layer may include a layer composed of, for example, an organic material. The organic material may have a refractive index equal or close to those of the organic layers 130A, 130B, and 130C in order to inhibit light from being refracted by the sealing layer. For example, the organic material may be sealed by using an inorganic material such as silicon nitride (SiN). In this case, the sealing layer may have a stacked structure in which a layer composed of the organic material and a layer composed of the inorganic material are stacked. A flattening layer (not illustrated) may be interposed between the second electrodes 140 and the sealing layer. The flattening layer may be used to improve the adhesion of the sealing layer by filling unevenness of the elements on the vapor deposition substrate 110.

A method of manufacturing the organic device 100 may include a step of forming the organic layers 130A, 130B, and 130C by attaching the vapor deposition material 82 to the vapor deposition substrate 110 by using the vapor deposition mask 10. More specifically, a method of manufacturing an organic EL display device according to the present embodiment may include a vapor deposition mask preparation step, a position adjustment step, a close contact step, a vapor deposition step, and a cutting step.

At the vapor deposition mask preparation step, the vapor deposition mask 10 described above may be prepared.

At the position adjustment step after the vapor deposition mask preparation step, the position of the vapor deposition mask 10 is adjusted with respect to the vapor deposition substrate 110. At the position adjustment step, the positions of the through-holes 40 of the vapor deposition mask 10 with respect to the vapor deposition substrate 110 are checked. At this time, the positions of the through-holes 40 of the vapor deposition mask 10 with respect to the vapor deposition substrate 110 may be adjusted. For example, the positions of the first alignment marks 45 that are provided on the substrate frame body 17 of the mask substrate 15 and the position of a corresponding substrate alignment mark 111 (see Fig. 3) of the vapor deposition substrate 110 are adjusted. In addition, the positions of the second alignment marks 46 that are provided on the mask sash bars 28a and 28b of the mask layer 20 and the position of a corresponding alignment mark (not illustrated) of the vapor deposition substrate 110 are adjusted. For example, the position of the vapor deposition substrate 110 and the positions of the through-holes 40 may be first roughly adjusted by using the first alignment marks 45, and subsequently, the position of the vapor deposition substrate 110 and the positions of the through-holes 40 may be finely adjusted by using the second alignment marks 46. This enables the positions of the through-holes 40 of the vapor deposition mask 10 with respect to the vapor deposition substrate 110 to be adjusted with precision.

At the close contact step after the position adjustment step, the first surface 20a of the mask layer 20 of the vapor deposition mask 10 may be brought into close contact with the vapor deposition substrate 110. More specifically, the first surface 20a of the mask layer 20 of the vapor deposition mask 10 is brought into close contact with the first surface 110a (see Fig. 3) of the vapor deposition substrate 110 in the vapor deposition apparatus 80 with the positions adjusted. At this time, the vapor deposition substrate 110 is interposed between the vapor deposition mask 10 and the magnet 85, and the vapor deposition mask 10 is attracted toward the vapor deposition substrate 110 due to the magnetic force of the magnet 85. Consequently, the vapor deposition substrate 110 comes into close contact with the first surface 20a of the vapor deposition mask 10.

At the close contact step, the first resin layer surface 21a of the resin layer 21 is in close contact with the first surface 110a of the vapor deposition substrate 110. In the case where the resin material of the resin layer 21 is polyimide, and the vapor deposition substrate 110 is a silicon substrate, the vapor deposition substrate 110 can be in contact with polyimide due to van der Waals force that acts between the polyimide and silicon. For this reason, the adhesion between the vapor deposition substrate 110 and the vapor deposition mask 10 can be improved. For this reason, the precision of the shapes and the precision of the positions of the organic layers 130A, 130B, and 130C that are formed on the vapor deposition substrate 110 can be improved. As a result, the definition of the organic device 100 can be improved.

At the vapor deposition step after the close contact step, the vapor deposition material 82 may be deposited on the first electrodes 120 that are formed on the vapor deposition substrate 110 via the through-holes 40 of the vapor deposition mask 10, and the organic layers 130A, 130B, and 130C may be formed (see Fig. 17B). The organic layers 130A, 130B, and 130C are formed on respective hole transport layers. More specifically, the pressure in the vapor deposition apparatus 80 is reduced to that in the vacuum atmosphere. Subsequently, the vapor deposition material 82 is vaporized and is caused to come to the hole transport layers. The vapor deposition material 82 that comes passes through the through-holes 40 of the vapor deposition mask 10 and are attached to desired hole transport layers. Consequently, the organic layers 130A, 130B, and 130C are formed on the first electrodes 120 and the insulating layer 160 in a pattern that corresponds to the pattern of the through-holes 40.

The organic layers 130A, 130B, and 130C are formed across the first electrodes 120 and the insulating layers 160 adjacent to the first electrodes 120. The organic layers 130A, 130B, and 130C adjacent to each other on the insulating layers 160 may overlap although this is not illustrated.

According to the present embodiment, the through-holes 40 are formed in the predetermined pattern in each of the effective regions 23 as described above. In the case where multiple colors are used for display, the vapor deposition mask 10 that include the through-holes 40 that are formed in the pattern that corresponds to the organic layers 130A, 130B, and 130C in the respective colors is prepared. The vapor deposition material 82 in each color is attached to the corresponding hole transport layer by using the corresponding vapor deposition mask 10. Consequently, an organic light-emitting material for red color, an organic light-emitting material for green color, and an organic light-emitting material for blue color, for example, can be deposited on the single vapor deposition substrate 110, and the organic layers 130A, 130B, and 130C can be formed.

After the organic layers 130A, 130B, and 130C are formed, the electron transport layers and the electron injection layers are formed on the organic layers 130A, 130B, and 130C. Subsequently, the second electrodes 140 are formed. The second electrodes 140 are formed so as to cover the respective organic layers 130A, 130B, and 130C and are formed across the first electrodes 120 and the insulating layers 160 adjacent to the first electrodes 120 on the organic layers 130A, 130B, and 130C. For example, the second electrodes 140 may be continuously formed across two of the organic layers 130A, 130B, and 130C adjacent to each other in a plan view.

The flattening layer and the sealing layer described above are formed on the second electrodes 140 formed. In this way, elements such as the organic layers 130A, 130B, and 130C that are provided on the vapor deposition substrate 110 are sealed by the sealing layer.

At the cutting step after the vapor deposition step, the vapor deposition substrate 110 is cut for every organic device 100. In this case, for example, the vapor deposition substrate 110 is cut between the organic devices 100 adjacent to each other by using the dicing saw. The vapor deposition substrate 110 may be cut by using the single sewing depending on the distance between the organic devices 100 adjacent to each other and the width of the dicing saw, or the vapor deposition substrate 110 may be cut by using the double sawing.

In this way, the organic device 100 that includes the organic layers 130A, 130B, and 130C in the respective colors that are formed on the vapor deposition substrate 110 is obtained.

According to the present embodiment, the vapor deposition mask 10 thus includes the mask layer 20 that includes the through-holes 40 and the mask substrate 15 that is located on the second surface 20b of the mask layer 20. The mask substrate 15 is thus located on the mask layer 20, consequently, the strength of the vapor deposition mask 10 can be improved, and the close contact with the vapor deposition substrate 110 can be achieved in this state. This enables the precision of the shapes and the precision of the positions of the through-holes 40 of the mask layer 20 to be maintained at the precision of the shapes and the precision of the positions at the time the through-holes 40 are formed, and the definition of the through-holes 40 can be improved. In addition, the high definition of the through-holes 40 can be achieved. The vapor deposition material 82 can be attached to the vapor deposition substrate 110 with the precision of the shapes and the precision of the positions of the through-holes 40 improved. For this reason, the definition of the organic layers 130A, 130B, and 130C of the organic device 100 can be improved. In this case, the high definition of the pixels that include the elements that include the organic layers 130A, 130B, and 130C can be achieved.

According to the present embodiment, the mask substrate 15 contains silicon. In the case where the vapor deposition substrate 110 is a silicon substrate, the mask substrate 15 can be composed of the same kind of material or the same material as the vapor deposition substrate 110. This enables a difference between the thermal expansion coefficient of the mask substrate 15 and the thermal expansion coefficient of the vapor deposition substrate 110 to be reduced. For this reason, the precision reduction can be inhibited from being made. For example, in the case where the pixel density of the organic device 100 is high, it is required that the precision of the shapes and the precision of the positions of the through-holes 40 are increased. The mask substrate 15 according to the present embodiment contains silicon, and accordingly, the difference in the thermal expansion coefficient from that of the vapor deposition substrate 110 can be reduced as described above. This enables the positions of the through-holes 40 to be inhibited from being shifted with respect to the vapor deposition substrate 110 even in the case where the vapor deposition mask 10 the position of which is adjusted with precision with respect to the vapor deposition substrate 110 thermally expands. For this reason, the precision of the shapes and the precision of the positions of the organic layers 130A, 130B, and 130C that are formed on the vapor deposition substrate 110 can be improved. As a result, the organic device 100 that includes the organic layers 130A, 130B, and 130C that have high definition can be easily manufactured.

According to the present embodiment, the second surface 20b of the mask layer 20 is attached to the mask substrate 15. This enables the strength of the vapor deposition mask 10 to be further improved. In the case where the mask layer 20 is manufactured alone as a body that is separated from the mask substrate 15, the mask layer 20 is stretched to a frame of, for example, the mask substrate 15 with a tension applied thereto and is subsequently fixed, for example, by being welded. However, since the mask layer 20 is attached to the mask substrate 15, the vapor deposition mask 10 according to the present embodiment can eliminate the need for such stretching the mask layer 20. This enables the precision of the shapes and the precision of the positions of the through-holes 40 of the mask layer 20 that is attached to the mask substrate 15 to be maintained at the precision of the shapes and the precision of the positions at the time the through-holes 40 are formed. For this reason, the definition of the through-holes 40 can be further improved.

According to the present embodiment, the mask layer 20 includes the resin layer 21 that forms the first surface 20a and the mask intermediate layer 22 that is located between the resin layer 21 and the mask substrate 15. This enables the mask intermediate layer 22 to have an inherent purpose. For example, the mask intermediate layer 22 can be composed of a material that enables adhesion between the resin layer 21 and the mask substrate 15 to be ensured. In this case, the vapor deposition mask 10 can be attached to the mask substrate 15, and the strength of the vapor deposition mask 10 can be further improved. Alternatively, the mask intermediate layer 22 can be composed of a material that has resistance against the etching medium that is used at the substrate etching step. In this case, the resin layer 21 can be inhibited from being etched by the etching medium at the substrate etching step.

According to the present embodiment, the resin layer 21 that forms the first surface 20a of the mask layer 20 contains a resin material. This enables the adhesion between the resin layer 21 and the vapor deposition substrate 110 to be improved when the vapor deposition mask 10 is brought into close contact with the vapor deposition substrate 110. For this reason, the precision of the shapes and the precision of the positions of the organic layers 130A, 130B, and 130C that are formed on the vapor deposition substrate 110 can be improved, and the definition of the organic device 100 can be improved.

According to the present embodiment, the thickness of the mask intermediate layer 22 that forms the second surface 20b of the mask layer 20 is less than the thickness of the resin layer 21 that forms the first surface 20a. This enables the mask intermediate layer 22 to have the inherent purpose. That is, in some cases where the mask intermediate layer 22 has the inherent purpose, it is thought that it is difficult to reduce the thermal expansion coefficient. An example of the purpose of the mask intermediate layer 22 is a purpose to ensure the adhesion to the resin layer 21, a purpose to ensure the adhesion to the mask substrate 15, or a purpose to reduce the erosion of the etching medium that is used at the substrate etching step. It is thought that the material for achieving the purposes has a large thermal expansion coefficient. Even in this case, however, reducing the thickness of the mask intermediate layer 22 enables the influence of the thermal expansion of the mask intermediate layer 22 to be reduced. For this reason, the precision reduction can be inhibited from being made.

According to the present embodiment, the mask intermediate layer 22 includes the body region portion 22a that is located between the resin layer 21 and the substrate frame body 17 and the mask layer opening 22d that is formed along the substrate opening 16 in a plan view. This enables the thickness of a portion of the mask layer 20 at which the through-holes 40 are formed to be reduced. For this reason, shadow can be inhibited from occurring.

According to the present embodiment, the opening dimension of the through-hole 40 in the predetermined direction at the second resin layer surface 21b is larger than the opening dimension of the through-hole 40 in the predetermined direction at the first resin layer surface 21a. This enables shadow to be inhibited from occurring in the case where the vapor deposition substrate 110 is brought into close contact with the first resin layer surface 21a during vapor deposition. For this reason, the precision of the shapes and the precision of the positions of the organic layers 130A, 130B, and 130C that are composed of the vapor deposition material 82 that is attached to the vapor deposition substrate 110 can be improved, and the definition of the organic device 100 can be improved.

According to the present embodiment, the two or more through-holes 40 are located in the substrate opening 16 of the mask substrate 15. This enables the mask substrate 15 to be inhibited from causing shadow to occur during vapor deposition. For this reason, the precision of the shapes and the precision of the positions of the organic layers 130A, 130B, and 130C that are composed of the vapor deposition material 82 that is attached to the vapor deposition substrate 110 can be improved, and the definition of the organic device 100 can be improved. According to the present embodiment, the multiple through-hole groups 30 are located in the substrate opening 16, and accordingly, shadow can be further inhibited from occurring.

According to the present embodiment, the first alignment marks 45 are provided on the surface of the mask substrate 15 opposite the mask layer 20. This enables the position of the vapor deposition mask 10 and the position of the vapor deposition substrate 110 to be adjusted by using the first alignment marks 45 at the position adjustment step at which the position of the vapor deposition mask 10 is adjusted with respect to the vapor deposition substrate 110. Since the first alignment marks 45 are provided on the mask substrate 15, the position of the vapor deposition mask 10 can be entirely adjusted to the position of the vapor deposition substrate 110.

According to the present embodiment, the second alignment marks 46 are provided at positions nearer than the first alignment marks 45 to the through-holes 40. This enables the position of the vapor deposition mask 10 and the position of the vapor deposition substrate 110 to be adjusted by using the second alignment marks 46 at the position adjustment step at which the position of the vapor deposition mask 10 is adjusted with respect to the vapor deposition substrate 110. The second alignment marks 46 are located at positions nearer than the first alignment marks 45 to the through-holes 40, and accordingly, the precision of the adjustment of the position of the vapor deposition mask 10 and the position of the vapor deposition substrate 110 can be improved. The second alignment marks 46 are provided on the first surface 20a of the mask layer 20, and consequently, the second alignment marks 46 can be visually recognized through the vapor deposition substrate 110 even in the case where the resin layer 21 does not have the optical transparency.

According to the present embodiment, the second alignment marks 46 are located on the mask sash bars 28a and 28b that are provided between the through-hole groups 30 adjacent to each other. This enables the second alignment marks 46 to be provided at positions nearer to the through-holes 40. For this reason, the precision of the adjustment of the position of the vapor deposition mask 10 and the position of the vapor deposition substrate 110 can be further improved. According to the present embodiment, the second alignment marks 46 are located at the intersecting portions 29 at which the first mask sash bars 28a and the second mask sash bars 28b intersect with each other. This enables the positions of the through-holes 40 in the through-hole groups 30 close to each other to be efficiently adjusted.

According to the present embodiment, the through-holes 40 are formed by irradiating the mask layer 20 with the laser light L. This enables the precision of the shapes and the precision of the positions of the through-holes 40 to be improved. For this reason, the definition of the vapor deposition mask 10 can be improved.

According to the present embodiment, the second resin layer surface 21b of the resin layer 21 is irradiated with the laser light L via the substrate opening 16 after the substrate opening 16 is formed. This enables the opening dimension of each through-hole 40 in the predetermined direction at the second resin layer surface 21b to be easily larger than the opening dimension of each through-hole 40 in the predetermined direction at the first resin layer surface 21a. Consequently, the through-holes 40 that enable shadow to be inhibited from occurring can be easily formed in the case where the vapor deposition substrate 110 is brought into close contact with the first resin layer surface 21a during vapor deposition. For this reason, the precision of the shapes and the precision of the positions of the organic layers 130A, 130B, and 130C that are composed of the vapor deposition material 82 that is attached to the vapor deposition substrate 110 can be improved, and the definition of the organic device 100 can be improved.

An embodiment described above can be modified in various ways. Modifications will now be described with reference to the drawings as needed. In the following description and the drawings that are used for the description, a portion that can be configured in the same manner as in an embodiment described above is designated by reference characters like to the reference characters that are used for the corresponding portion according to an embodiment described above, and a duplicated description is omitted. In the case where the action and effect according to an embodiment described above are clearly achieved also according to the modifications, the description thereof is omitted in some cases.

A first modification will now be described.

In an example according to the present embodiment described above, the mask intermediate layer 22 includes the mask layer opening 22d that is formed along the substrate opening 16 in a plan view. The present disclosure, however, is not limited thereto.

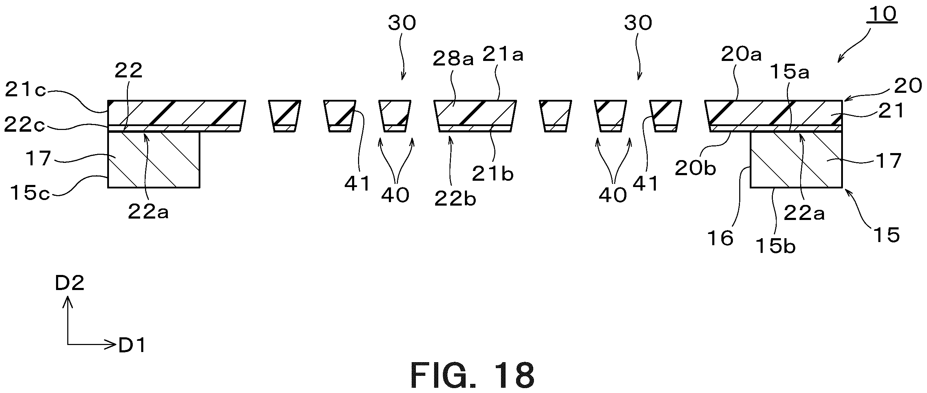

For example, as illustrated in Fig. 18, the mask intermediate layer 22 may not include the mask layer opening 22d. In this case, the mask intermediate layer 22 may include the body region portion 22a that is located between the resin layer 21 and the substrate frame body 17 and an opening region portion 22b that is located in the substrate opening 16 in a plan view. In an example illustrated in Fig. 18, the mask intermediate layer 22 is formed on the whole of the second resin layer surface 21b of the resin layer 21. As for the mask intermediate layer 22, for example, a resist layer (not illustrated) may be formed on a portion of the mask intermediate layer 22 in the substrate opening 16 in a plan view at the mask protection layer removal step (see Fig. 14) described above. In the example illustrated in Fig. 18, the through-holes 40 extend through the mask layer 20. That is, the through-holes 40 extend from the first surface 20a to the second surface 20b.

The opening dimension of each through-hole 40 in the predetermined direction (such as the first direction D11 or the second direction D12) at the second surface 20b of the mask layer 20 may be larger than the opening dimension of each through-hole 40 in the predetermined direction at the first surface 20a. According to an embodiment, the sectional openings of the through-holes 40 in a direction parallel with the first surface 20a may be gradually increased in a direction from the first surface 20a toward the second surface 20b. In other words, the sectional areas of the through-holes 40 in a section parallel with the first surface 20a at positions in the normal direction of the mask layer 20 may be gradually increased in the direction from the first surface 20a toward the second surface 20b. In this case, the through-holes 40 may include the wall surfaces 41 that are gradually separated from the central axes CL of the through-holes 40 in the direction from the first surface 20a toward the second surface 20b. In the example illustrated in Fig. 18, the wall surfaces 41 of the through-holes 40 are linearly inclined with respect to the central axes CL so as to be separated from the central axes CL in the direction from the first surface 20a toward the second surface 20b. For example, the opening dimension of each through-hole 40 at the first surface 20a of the mask layer 20 may be the opening dimension illustrated in Fig. 5A by using the reference characters S1. The opening dimension of each through-hole 40 at the second surface 20b may be the opening dimension illustrated in Fig. 5A by using the reference characters S2.

The through-hole formation step may be performed after the mask protection layer removal step. At the through-hole formation step in this case, the second surface 20b of the mask layer 20 is irradiated with the laser light L via the substrate opening 16. Consequently, the through-holes 40 that extend through the mask intermediate layer 22 and the resin layer 21 are formed in the mask intermediate layer 22 and the resin layer 21.

According to the first modification, the mask intermediate layer 22 thus includes the opening region portion 22b. This enables the necessity of removal of the opening region portion 22b to be eliminated and enables the strength of the mask layer 20 to be improved.

A second modification will now be described.

In an example according to the present embodiment described above, the mask intermediate layer 22 is formed on the mask substrate 15 by performing the sputtering process. The present disclosure, however, is not limited thereto, and the mask intermediate layer 22 may be formed by performing the vapor deposition process such as physical vapor deposition (PVD) or chemical vapor deposition (CVD).

A third modification will now be described.

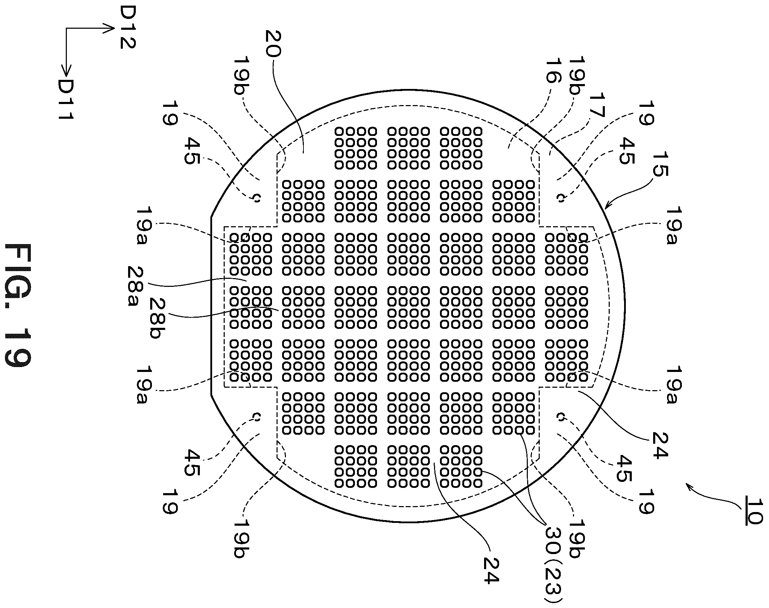

In an example according to the present embodiment described above, the first alignment marks 45 for adjusting the position of the vapor deposition substrate 110 is provided on the substrate frame body 17 of the mask substrate 15. The present disclosure, however, is not limited thereto. For example, as illustrated in Fig. 19, the mask substrate 15 may include inner projecting portions 19 that extend inward from the substrate frame body 17 in a plan view, and the first alignment marks 45 may be located on the inner projecting portions 19. Each inner projecting portion 19 may include a side wall 19a that faces the through-hole groups 30 adjacent to each other in the first direction D11 and a side wall 19b that faces the through-hole groups 30 adjacent to each other in the second direction D12. In a plan view, the side wall 19a may extend in the second direction D12, and the side wall 19b may extend in the first direction D11. The first alignment marks 45 are provided on the inner projecting portions 19, consequently, the first alignment marks 45 can be located near the through-hole groups 30, and the positions of the through-holes 40 can be adjusted with improved precision.

A fourth modification will now be described.

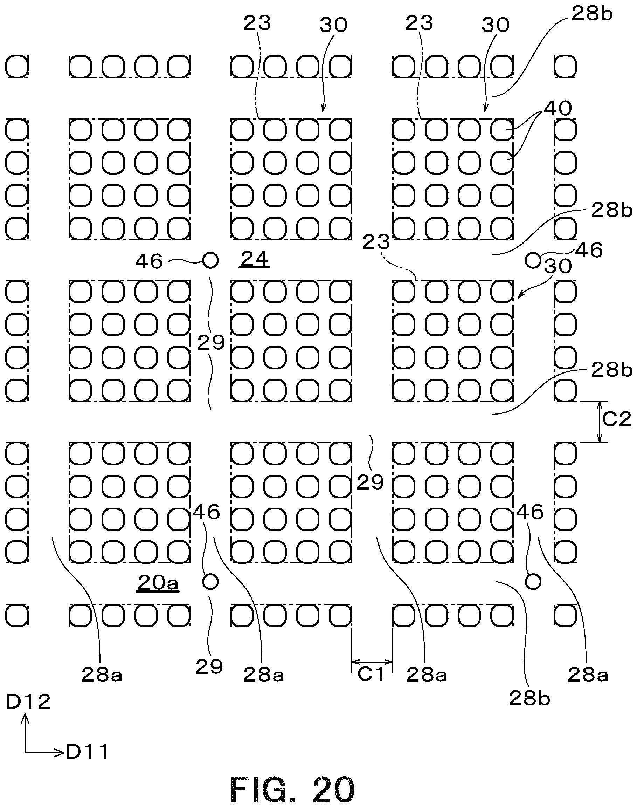

In an example according to the present embodiment described above, the second alignment marks 46 for adjusting the position of the vapor deposition substrate 110 are provided at the intersecting portions 29 at which the first mask sash bars 28a and the second mask sash bars 28b of the mask layer 20 intersect with each other. The present disclosure, however, is not limited thereto, and as illustrated in Fig. 20, the second alignment marks 46 may not be provided at all of the intersecting portions 29. For example, the second alignment marks 46 may be provided for respective sets of the multiple through-hole groups 30 in the first direction D11. In Fig. 20, the second alignment marks 46 are provided for respective two sets of the through-hole groups 30 in the first direction D11 and the second direction D12. More specifically, the second alignment marks 46 may be provided on one of two first mask sash bars 28a adjacent to each other in the first direction D11, and no second alignment marks 46 may be provided on the other of the second alignment marks 46. The second alignment marks 46 may be provided on one of two second mask sash bars 28b adjacent to each other in the second direction D12, and no second alignment marks 46 may be provided on the other of the second alignment marks 46. In this case, the second alignment mark 46 is provided at a position that corresponds to the corner portions of four of the through-hole groups 30.

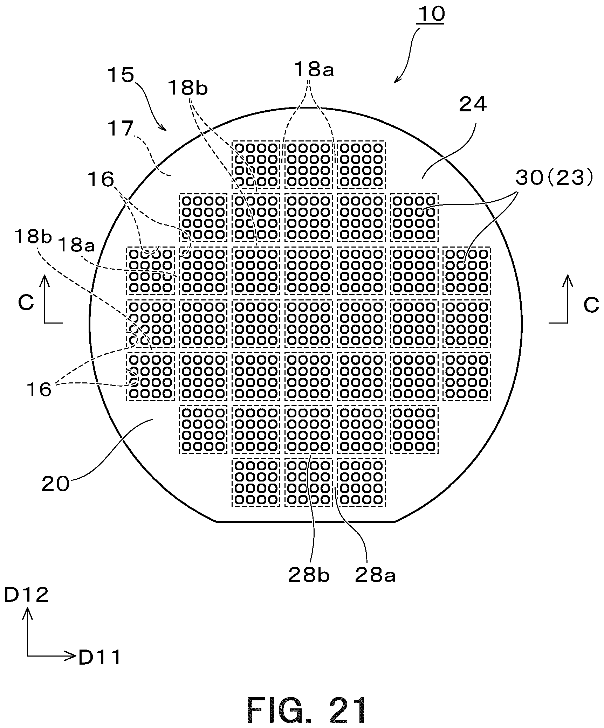

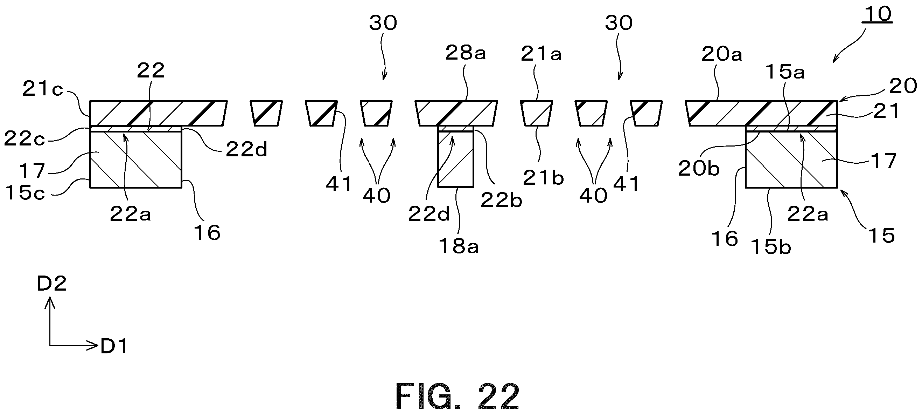

The second alignment marks 46 may not be provided on the mask layer 20 but may be provided on substrate sash bars 18a and 18b (see Fig. 21 and Fig. 22) of the mask substrate 15 described later although this is not illustrated. In the case where the second alignment marks 46 are formed in a recessed shape, the second alignment marks 46 may be formed on the second substrate surface 15b at the substrate sash bars 18a and 18b. In this case, the second alignment marks 46 can be visually recognized through the vapor deposition substrate 110 and the mask layer 20 by radiating infrared rays. In a plan view, the second alignment marks 46 may be located at the same positions as those of the second alignment marks 46 illustrated in Fig. 3 or may be located at the same positions as those of the second alignment marks 46 illustrated in Fig. 20, which is freely determined. The second alignment marks 46 in the recessed shape may be formed by etching the second substrate surface 15b at the substrate sash bars 18a and 18b at the substrate etching step.

A fifth modification will now be described.

In an example according to the present embodiment described above, all of the through-hole groups 30 are located in the single substrate opening 16 of the mask substrate 15. The present disclosure, however, is not limited thereto, and the mask substrate 15 may include multiple substrate openings 16. For example, as illustrated in Fig. 21 and Fig. 22, the substrate sash bars 18a and 18b may be provided between the substrate openings 16 adjacent to each other. The substrate sash bars 18a and 18b may include first substrate sash bars 18a that are arranged in the first direction D11 and second substrate sash bars 18b that are arranged in the second direction D12. The first substrate sash bars 18a may extend in the second direction D12. The first substrate sash bars 18a may overlap the first mask sash bars 28a described above in a plan view. The second substrate sash bars 18b may extend in the first direction D11. The second substrate sash bars 18b may overlap the second mask sash bars 28b described above in a plan view. The mask intermediate layer 22 may include the body region portion 22a, multiple mask layer openings 22d, and a mask intermediate layer sash bar 22e. The mask layer openings 22d are formed along the substrate openings 16 that correspond thereto. The mask intermediate layer sash bar 22e is formed along the substrate sash bars 18a and 18b. Fig. 22 schematically illustrates a section taken along a line C-C in Fig. 21 where the number of the through-hole groups 30 and the number of the through-holes 40 are reduced to make the figure easy to understand.

In an example illustrated in Fig. 21 and Fig. 22, a corresponding one of the through-hole groups 30 (or the effective regions 23) is located in each substrate opening 16. The substrate openings 16 illustrated in Fig. 21 and Fig. 22 may have shapes that is formed along the contours of the respective through-hole groups 30 (or the respective effective regions 23). The substrate sash bars 18a and 18b are connected to the substrate frame body 17 and are located between the through-hole groups 30 adjacent to each other in a plan view. Fig. 22 illustrates the first substrate sash bars 18a, and the first substrate sash bars 18a extend in a direction perpendicular to the paper. Both ends of each first substrate sash bar 18a are connected to the substrate frame body 17 so as to be continuous thereto. The second substrate sash bars 18b extend in a left-right direction in Fig. 22 although this is not illustrated in Fig. 22. Both ends of each second substrate sash bar 18b are connected to the substrate frame body 17 so as to be continuous thereto. In this way, the multiple substrate openings 16 are defined by the first substrate sash bars 18a that extend in the second direction D12 and the second substrate sash bars 18b that extend in the first direction D11 in a plan view.

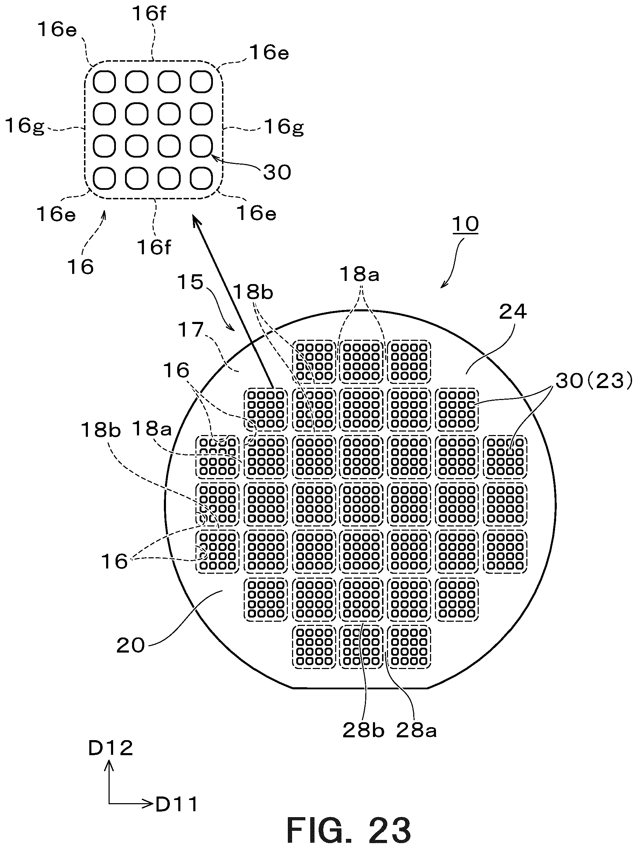

In the example illustrated in Fig. 21, the substrate openings 16 have a contour that has a substantially rectangular shape in a plan view. The four corners of the contour of each substrate opening 16 may be formed in a manner in which sides 16f (see Fig. 23) that extend in the first direction D11 and sides 16g that extends in the second direction D12, which form the contour of the substrate opening 16, directly intersect with each other. However, a contour that has a small, curved shape and that is unintentionally formed may be interposed between the sides. The present disclosure, however, is not limited thereto.

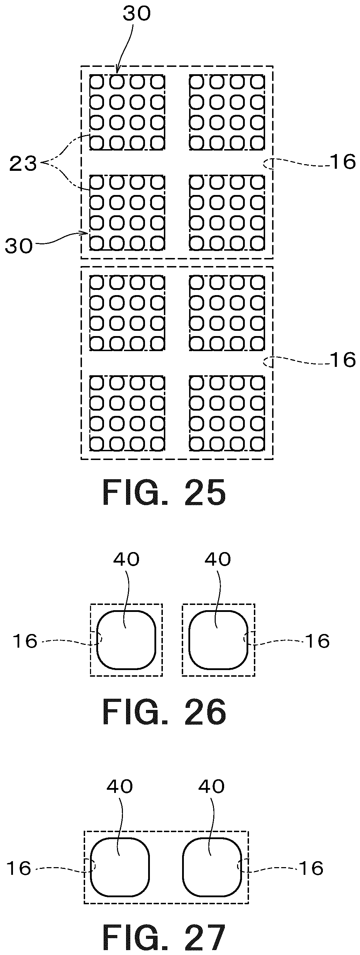

For example, as for each substrate opening 16, as illustrated in, Fig. 23, curved portions 16e may be provided at the four corners of the contour of the substrate opening 16 that has a substantially rectangular shape in a plan view. The curved portions 16e connect the sides 16f that extend in the first direction D11 and the sides 16g that extend in the second direction D12 in the contour of the substrate opening 16 to each other into rounded shapes. The curved portions 16e may be intentionally formed so as to form a contour that has a curved shape. For example, the curved portions 16e may be formed in an arc shape. The curved portions 16e may be included in the substrate openings 16 illustrated in Fig. 25 to Fig. 27.

For example, the radius R of each curved portion 16e illustrated in Fig. 23 may be 0.3 mm or more, may be 0.6 mm or more, may be 0.9 mm or more, or may be 1.2 mm or more. When the radius R is 0.3 mm or more, stress can be inhibited from being concentrated on the four corners of each substrate opening 16. For example, the radius R may be 1.5 mm or less, may be 2.0 mm or less, may be 2.5 mm or less, or may be 3.0 mm or less. When the radius R is 3.0 mm or less, the number of the through-holes 40 that can be located in the substrate opening 16 can be inhibited from being limited. The range of the radius R may be determined by using a first group consisting of 0.3 mm, 0.6 mm, 0.9 mm, and 1.2 mm and/or a second group consisting of 1.5 mm, 2.0 mm, 2.5 mm, and 3.0 mm. The range of the radius R may be determined by using a combination of a freely selected one of values in the first group described above and a freely selected one of values in the second group described above. The range of the radius R may be determined by using a combination of freely selected two of values in the first group described above. The range of the radius R may be determined by using a combination of freely selected two of values in the second group described above. For example, the range may be 0.3 mm or more and 3.0 mm or less, may be 0.3 mm or more and 2.5 mm or less, may be 0.3 mm or more and 2.0 mm or less, may be 0.3 mm or more and 1.5 mm or less, may be 0.3 mm or more and 1.2 mm or less, may be 0.3 mm or more and 0.9 mm or less, may be 0.3 mm or more and 0.6 mm or less, may be 0.6 mm or more and 3.0 mm or less, may be 0.6 mm or more and 2.5 mm or less, may be 0.6 mm or more and 2.0 mm or less, may be 0.6 mm or more and 1.5 mm or less, may be 0.6 mm or more and 1.2 mm or less, may be 0.6 mm or more and 0.9 mm or less, may be 0.9 mm or more and 3.0 mm or less, may be 0.9 mm or more and 2.5 mm or less, may be 0.9 mm or more and 2.0 mm or less, may be 0.9 mm or more and 1.5 mm or less, may be 0.9 mm or more and 1.2 mm or less, may be 1.2 mm or more and 3.0 mm or less, may be 1.2 mm or more and 2.5 mm or less, may be 1.2 mm or more and 2.0 mm or less, may be 1.2 mm or more and 1.5 mm or less, may be 1.5 mm or more and 3.0 mm or less, may be 1.5 mm or more and 2.5 mm or less, may be 1.5 mm or more and 2.0 mm or less, may be 2.0 mm or more and 3.0 mm or less, may be 2.0 mm or more and 2.5 mm or less, or may be 2.5 mm or more and 3.0 mm or less.

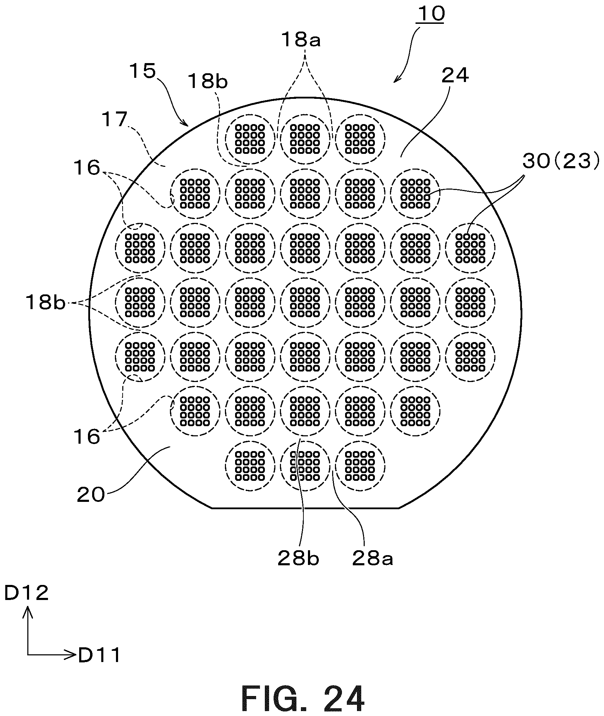

As illustrated in Fig. 24, the substrate openings 16 may have a contour that has a circular shape in a plan view. At the substrate etching step illustrated in Fig. 11, portions of the mask substrate 15 that correspond to the substrate sash bars 18a and 18b are not etched but remain, and consequently, the substrate sash bars 18a and 18b can be formed.

The mask substrate 15 thus includes the multiple substrate openings 16, and consequently, the mask layer 20 can be supported by the material (the substrate sash bars 18a and 18b) of the mask substrate 15 that remains between the substrate openings 16. For this reason, the mechanical strength of the vapor deposition mask 10 can be improved.

In the case where the mask substrate 15 includes the multiple substrate openings 16, as illustrated in Fig. 21 to Fig. 24, it is not limited that one of the through-hole groups 30 is located in one of the substrate openings 16. For example, as illustrated in Fig. 25, two or more through-hole groups 30 (or the effective regions 23) may be located in one of the substrate openings 16. In an example illustrated in Fig. 25, the four through-hole groups 30 are located in one of the substrate openings 16. Alternatively, it is not limited that all of the through-holes 40 that form one of the through-hole groups 30 are located in the one of the substrate opening 16. For example, one of the through-hole groups 30 may be across two or more substrate openings 16 in a plan view. For example, as illustrated in Fig. 26, one of the through-holes 40 may be located in one of the substrate openings 16. In an example illustrated in Fig. 26, the substrate openings 16 are provided for the respective through-holes 40. As illustrated in Fig. 27, two or more through-holes 40 may be located in one of the substrate openings 16. In an example illustrated in Fig. 27, two through-holes 40 are located in one of the substrate openings 16.

A sixth modification will now be described.

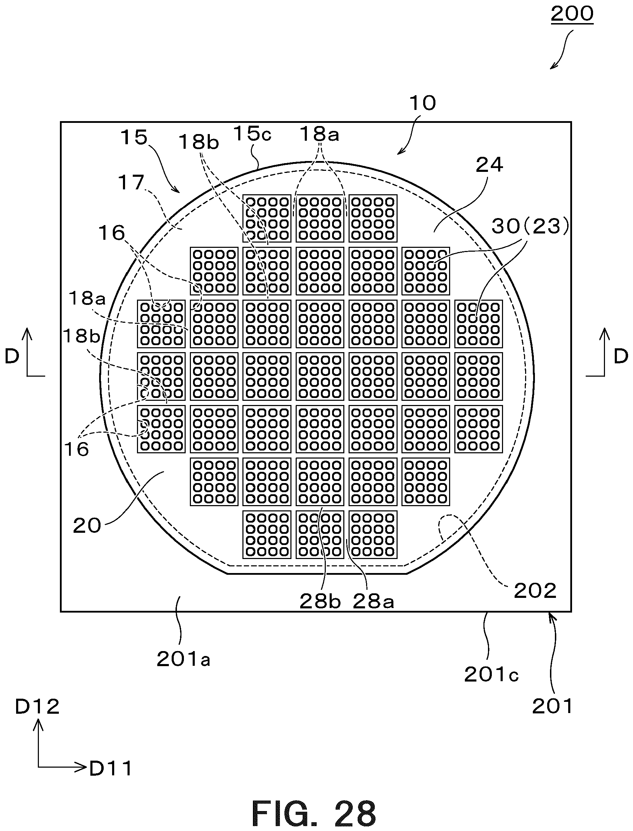

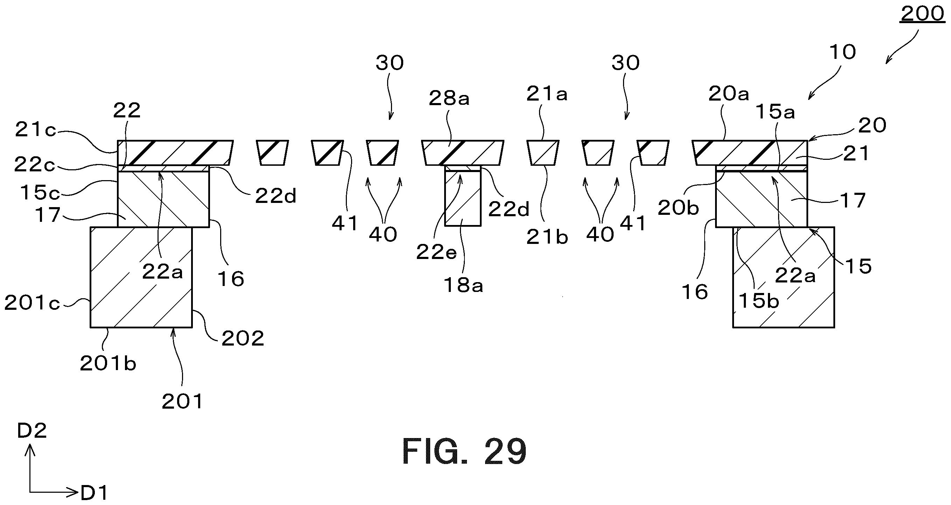

In an example according to the present embodiment described above, the vapor deposition mask 10 includes the mask layer 20 and the mask substrate 15. The present disclosure, however, is not limited thereto. For example, as illustrated in Fig. 28 and Fig. 29, the mask substrate 15 may be supported by a frame 201. In this case, a framed vapor deposition mask 200 may include the vapor deposition mask 10 and the frame 201.

More specifically, the framed vapor deposition mask 200 includes the vapor deposition mask 10 and the frame 201 that supports the mask substrate 15 of the vapor deposition mask 10. The frame 201 may be attached to the mask substrate 15 of the vapor deposition mask 10 when the vapor deposition mask 10 is used, for example, in order to hold the vapor deposition mask 10 when the vapor deposition mask 10 is moved. Consequently, the vapor deposition mask 10 can be used while the frame 201 is held, and the vapor deposition mask 10 can be inhibited from being damaged. As a result, handling of the vapor deposition mask 10 can be improved.

The frame 201 may include a first frame surface 201a and a second frame surface 201b. The first frame surface 201a faces the mask substrate 15 and faces the second substrate surface 15b of the mask substrate 15. The second frame surface 201b is located opposite the first frame surface 201a. The first frame surface 201a is connected to the substrate frame body 17 of the mask substrate 15. The frame 201 does not overlap the substrate openings 16 in a plan view. At least a portion of the frame 201 extends outward beyond the outer edge 15c of the mask substrate 15 in a plan view. Consequently, a region for holding the frame 201 when the vapor deposition mask 10 is used is formed. In an example illustrated in Fig. 28, the frame 201 entirely extends outward beyond the outer edge 15c of the mask substrate 15.

The frame 201 may contain a glass material or a metal material. Examples of the glass material may include quartz glass, borosilicate glass, alkali-free glass or soda glass. Examples of the metal material may include an invar material, aluminum, and stainless steel such as SUS430 or SUS304. The use of the material for the frame 201 enables the rigidity of the frame 201 to be greater than that of the mask substrate 15. The frame 201 may contain a silicon or resin material. The material of the frame 201 may be determined such that the frame 201 has the required rigidity in consideration of holding force of an operator who uses the framed vapor deposition mask 200 or a robot hand.

The thermal expansion coefficient of the frame 201 may be equal or close to the thermal expansion coefficient of the mask substrate 15. This enables the expansion rates of the frame 201 and the mask substrate 15 to be equal to each other when the framed vapor deposition mask 200 is heated. As a result, the mask substrate 15 can be inhibited from being damaged. In addition, the precision of the positions of the through-holes 40 can be improved, and the precision of vapor deposition can be improved. More specifically, the absolute value of a difference between the thermal expansion coefficient of the frame 201 and the thermal expansion coefficient of the mask substrate 15 may be 15 ppm/°C or less, may be 10 ppm/°C or less, or may be 5.0 ppm/°C or less. The material of the frame 201 may be a material that has high thermal conductivity. In this case, the vapor deposition mask 10 can be efficiently cooled.

In an illustrated example, the frame 201 has an annular shape. A portion of the frame 201 that is located outside the outer edge 15c of the mask substrate 15 in a plan view can have an annular shape. This enables the substrate frame body 17 of the mask substrate 15 to be effectively inhibited from being damaged when the vapor deposition mask 10 is used. More specifically, a frame opening 202 that extends from the first frame surface 201a to the second frame surface 201b through the frame 201 is formed at the center of the frame 201. In the illustrated example, the planar shape of the frame opening 202 is similar to the planar shape of the outer edge 15c of the mask substrate 15. The frame opening 202 overlaps the substrate openings 16 of the mask substrate 15 in a plan view. In the illustrated example, the mask substrate 15 includes the first substrate sash bars 18a and the second substrate sash bars 18b described above, and the substrate sash bars 18a and 18b define the multiple substrate openings 16 as in the example illustrated in Fig. 21 and Fig. 22. The frame opening 202 overlaps the first substrate sash bars 18a and the second substrate sash bars 18b of the mask substrate 15 in a plan view.

The planar shape of an outer edge 201c of the frame 201 is freely determined. In the illustrated example, in a plan view, the outer edge 201c of the frame 201 has a rectangular shape but may have another polygonal shape or a circular shape.

In an example according to the sixth modification described above, the mask substrate 15 of the vapor deposition mask 10 according to the fifth modification illustrated in Fig. 21 and Fig. 22 is supported by the frame 201. The present disclosure, however, is not limited thereto. The mask substrate 15 of the vapor deposition mask 10 illustrated in Fig. 3 may be supported by the frame 201, or the mask substrate 15 of the vapor deposition mask 10 according to another modification may be supported by the frame 201. For example, the mask intermediate layer 22 illustrated in Fig. 29 may not include the mask layer opening 22d, but the mask intermediate layer 22 may include the opening region portion 22b (see Fig. 18).

A seventh modification will now be described.

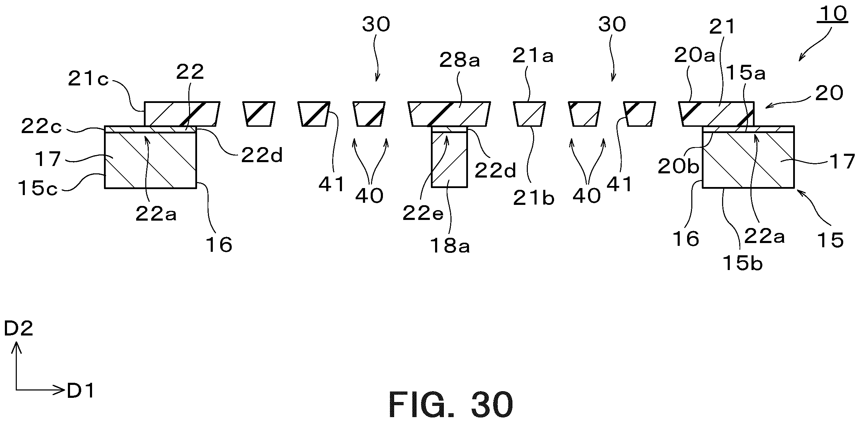

In an example according to the present embodiment described above, the outer edge 21c of the resin layer 21 overlaps the outer edge 22c of the mask intermediate layer 22 in a plan view. The present disclosure, however, is not limited thereto. For example, as illustrated in Fig. 30, the outer edge 21c of the resin layer 21 may be located inside the outer edge 22c of the mask intermediate layer 22. In other words, the mask intermediate layer 22 extends outward beyond the outer edge 21c of the resin layer 21 and is exposed. This enables a step to be formed by the resin layer 21 and the mask intermediate layer 22 and enables the thickness H3 (see Fig. 3) of the resin layer 21 to be easily measured. A portion of the mask intermediate layer 22 may extend outward beyond the outer edge 21c of, for example, the resin 21 in a plan view. In this case, the step can be formed at a portion of the outer edge 21c of the resin layer 21 in a plan view. However, the mask intermediate layer 22 may entirely extend outward beyond the outer edge 21c of the resin layer 21 in a plan view. In this case, the step can be formed over the entire circumference of the outer edge 21c of the resin layer 21 in a plan view.

At the resin layer formation step at which the resin layer 21 is formed, a resist layer, not illustrated, may be formed on the surface of the mask intermediate layer 22 opposite the mask substrate 15 in advance. The resist layer is located in a region close to the outer edge 22c of the mask intermediate layer 22. This enables the resin layer 21 that includes the outer edge 21c described above to be formed.

The outer edge 21c of the resin layer 21 is thus located inside the outer edge 22c of the mask intermediate layer 22, and consequently, the thickness H3 of the resin layer 21 can be easily measured.

In an example according to the seventh modification described above, the outer edge 21c of the resin layer 21 of the vapor deposition mask 10 according to the fifth modification illustrated in Fig. 21 and Fig. 22 is located inside the outer edge 22c of the mask intermediate layer 22. The present disclosure, however, is not limited thereto. For example, the outer edge 21c of the resin layer 21 of the vapor deposition mask 10 illustrated in Fig. 3 may be located inside the outer edge 22c of the mask intermediate layer 22, and the outer edge 21c of the resin layer 21 of the vapor deposition mask 10 according to another modification may be located inside the outer edge 22c of the mask intermediate layer 22. For example, the mask intermediate layer 22 illustrated in Fig. 30 may not include the mask layer opening 22d, but the mask intermediate layer 22 may include the opening region portion 22b (see Fig. 18).

An eighth modification will now be described.

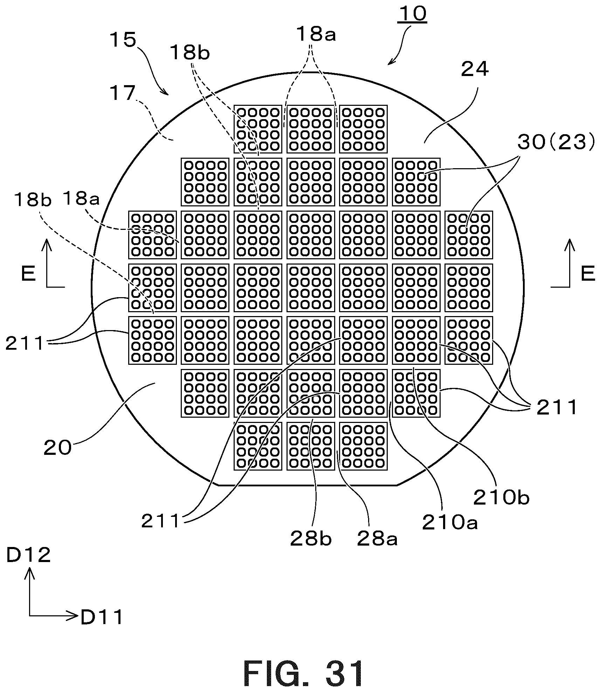

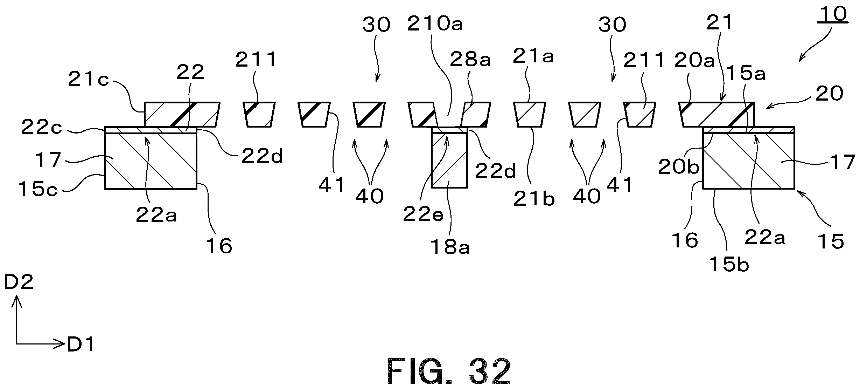

In an example according to the present embodiment described above, the mask sash bars 28a and 28b of the resin layer 21 are formed on the first substrate sash bars 18a and the second substrate sash bars 18b of the mask substrate 15. The present disclosure, however, is not limited thereto. For example, as illustrated in Fig. 31 and Fig. 32, resin grooves 210a and 210b may be formed in the mask sash bars 28a and 28b of the resin layer 21. The resin grooves 210a and 210b may extend through the resin layer 21. The resin grooves 210a and 210b may not be formed in the mask intermediate layer 22.

As illustrated in Fig. 31 and Fig. 32, multiple first resin grooves 210a and multiple second resin grooves 210b may be formed in the resin layer 21. The first resin grooves 210a may be formed in the first mask sash bars 28a and may overlap the first substrate sash bars 18a in a plan view. The first resin grooves 210a may extend in the second direction D12 and may be arranged in the first direction D11. The second resin grooves 210b may be formed in the second mask sash bars 28b and may overlap the second substrate sash bars 18b in a plan view. The second resin grooves 210b may extend in the first direction D11 and may be arranged in the second direction D12.

In an example illustrated in Fig. 31 and Fig. 32, the resin layer 21 may include multiple resin islands 211. The resin islands 211 are examples of a body island. The resin islands 211 may be defined by the first resin grooves 210a and the second resin grooves 210b. The resin islands 211 may be formed for every one of the through-hole groups 30 (or the effective regions 23). One of the through-hole groups 30 may be formed on one of the resin islands 211. Alternatively, two or more through-hole groups 30 may be formed on one of the resin islands 211. The resin islands 211 may have a rectangular shape in a plan view. In an example illustrated in Fig. 31, the multiple resin islands 211 are formed on the mask intermediate layer 22. The resin layer 21 may not be formed outside the resin island 211 that is located at the outermost position in a plan view among the multiple resin islands 211. In this case, the mask intermediate layer 22 is exposed, and the same step as that in Fig. 30 is formed by the resin layer 21 and the mask intermediate layer 22.

The resin grooves 210a and 210b may be formed by irradiating the resin layer 21 with laser light.

The resin grooves 210a and 210b are thus formed in the resin layer 21, and consequently, the resin layer 21 can be divided. For this reason, a warp that is generated on the resin layer 21 can be divided, and the vapor deposition mask 10 can be inhibited from warping.

In an example according to the eighth modification described above, the resin grooves 210a and 210b are formed in the resin layer 21 of the vapor deposition mask 10 according to the fifth modification illustrated in Fig. 21 and Fig. 22. The present disclosure, however, is not limited thereto. For example, the resin grooves 210a and 210b may be formed in the resin layer 21 of the vapor deposition mask 10 illustrated in Fig. 3, or the resin grooves 210a and 210b may be formed in the resin layer 21 of the vapor deposition mask 10 according to another modification. For example, the mask intermediate layer 22 illustrated in Fig. 32 may not include the mask layer opening 22d, but the mask intermediate layer 22 may include the opening region portion 22b (see Fig. 18).

The modifications to the embodiment described above are described, and the multiple modifications can naturally be appropriately combined and used.

## Claims

1. A vapor deposition mask comprising:
a mask substrate that contains silicon;
a mask layer that includes a first surface and a second surface that is located opposite the first surface and that faces the mask substrate; and
a through-hole that extends through the mask layer,
wherein the mask substrate includes a substrate opening,
wherein the through-hole is located in the substrate opening in a plan view,
wherein the mask layer includes a mask body layer that forms the first surface and a mask intermediate layer that is located between the mask body layer and the mask substrate, and
wherein the mask body layer contains a resin material.

2. The vapor deposition mask according to claim 1, wherein a thickness of the mask intermediate layer is less than a thickness of the mask body layer.

3. The vapor deposition mask according to claim 1 or 2, wherein the mask intermediate layer contains gold, aluminum, chromium, nickel, titanium, titanium nitride, an aluminum alloy that contains neodymium, a silicon oxide, or a silicon dioxide, and
wherein the mask intermediate layer is in contact with the mask body layer and is in contact with the mask substrate.

4. The vapor deposition mask according to claim 1 or 2, wherein the resin material of the mask body layer contains polyimide.

5. The vapor deposition mask according to claim 1 or 2, wherein the mask substrate includes a substrate body that defines the substrate opening,
wherein the mask intermediate layer includes a body region portion that is located between the mask body layer and the substrate body and a mask layer opening that is formed along the substrate opening in a plan view, and
wherein the through-hole extends through the mask body layer.

6. The vapor deposition mask according to claim 5, wherein an opening dimension of the through-hole in a predetermined direction at a surface of the mask body layer facing the mask substrate is larger than an opening dimension of the through-hole in the predetermined direction at the first surface.

7. The vapor deposition mask according to claim 1 or 2, wherein the mask substrate includes a substrate body that defines the substrate opening,
wherein the mask intermediate layer includes a body region portion that is located between the mask body layer and the substrate body and an opening region portion that is located in the substrate opening in a plan view, and
wherein the through-hole extends through the mask body layer and the opening region portion.

8. The vapor deposition mask according to claim 7, wherein an opening dimension of the through-hole in a predetermined direction at the second surface is larger than an opening dimension of the through-hole in the predetermined direction at the first surface.

9. The vapor deposition mask according to claim 1 or 2, wherein the mask layer includes two or more of the through-holes, and
wherein the two or more of the through-holes are located in the substrate opening in a plan view.

10. The vapor deposition mask according to claim 9, wherein the mask layer includes two or more through-hole groups that are formed by the two or more of the through-holes, and
wherein the two or more through-hole groups are located in the substrate opening in a plan view.

11. The vapor deposition mask according to claim 9, wherein the mask substrate includes two or more of the substrate openings,
wherein the mask layer includes two or more through-hole groups that are formed by the two or more of the through-holes, and
wherein the two or more through-hole groups are located in each substrate opening in a plan view.

12. The vapor deposition mask according to claim 9, wherein the mask substrate includes two or more of the substrate openings,
wherein the mask layer includes two or more through-hole groups that are formed by the two or more of the through-holes, and
wherein a corresponding one of the through-hole groups is located in each substrate opening in a plan view.

13. The vapor deposition mask according to claim 1 or 2, wherein the substrate opening has a rectangular shape in a plan view, and
wherein curved portions are provided at four corners of a contour of the substrate opening in a plan view.

14. The vapor deposition mask according to claim 1 or 2, wherein a first alignment mark is provided on a surface of the mask substrate opposite the mask layer.

15. The vapor deposition mask according to claim 14, wherein the mask substrate includes a substrate body that defines the substrate opening and an inner projecting portion that projects inward from the substrate body in a plan view, and
wherein the first alignment mark is located on the inner projecting portion.

16. The vapor deposition mask according to claim 14, wherein a second alignment mark is provided at a position nearer than the first alignment mark to the through-hole.

17. The vapor deposition mask according to claim 16, wherein the mask layer includes two or more of the through-holes, two or more through-hole groups that are formed by the two or more of the through-holes and a mask sash bar that is provided between the through-hole groups adjacent to each other, and
wherein the second alignment mark is located on the mask sash bar.

18. The vapor deposition mask according to claim 17, wherein the mask sash bar includes a first mask sash bar and a second mask sash bar that extend in respective directions perpendicular to each other in a plan view, and
wherein the second alignment mark is located at an intersecting portion at which the first mask sash bar and the second mask sash bar intersect with each other.

19. The vapor deposition mask according to claim 1 or 2, wherein an outer edge of the mask body layer is located inside an outer edge of the mask intermediate layer in a plan view.

20. The vapor deposition mask according to claim 1 or 2, wherein the mask body layer includes two or more body islands, and
wherein a groove that extends through the mask body layer is located between two of the body islands adjacent to each other.

21. A framed vapor deposition mask comprising:
the vapor deposition mask according to claim 1 or 2; and
a frame that supports the mask substrate of the vapor deposition mask.

22. A method of manufacturing a vapor deposition mask, the method comprising:
a substrate preparation step of preparing a mask substrate that contains silicon;
a mask layer formation step of forming a mask layer that includes a first surface and a second surface that is located opposite the first surface and that faces the mask substrate on the mask substrate;
a substrate opening formation step of forming a substrate opening in the mask substrate; and
a through-hole formation step of forming a through-hole that extends through the mask layer,
wherein the through-hole is located in the substrate opening in a plan view,
wherein the mask layer formation step includes a mask intermediate layer formation step of forming a mask intermediate layer on a surface of the mask substrate facing the mask layer and a mask body layer formation step of forming a mask body layer on a surface of the mask intermediate layer opposite the mask substrate, and
wherein the mask body layer contains a resin material.

23. The method according to claim 22, wherein at the through-hole formation step, the through-hole is formed by irradiating the mask layer with laser light.

24. The method according to claim 23, wherein the through-hole formation step is performed after the substrate opening formation step, and
wherein the mask layer is irradiated with the laser light via the substrate opening.

25. The method according to claim 23 or 24, wherein at the through-hole formation step, the mask layer is irradiated with the laser light via a mask hole that corresponds to the through-hole of a photo mask.

26. The method according to claim 25, wherein the photo mask has a plurality of the mask holes, and
wherein at the through-hole formation step, the mask layer is irradiated with the laser light via the plurality of the mask holes of the photo mask.

27. The method according to any one of claims 22 to 24, further comprising: a mask layer opening formation step of forming a mask layer opening in the mask intermediate layer along the substrate opening in a plan view after the substrate opening formation step,
wherein at the through-hole formation step, the through-hole is formed so as to extend through the mask body layer.

28. The method according to claim 27, wherein an opening dimension of the through-hole in a predetermined direction at a surface of the mask body layer facing the mask substrate is larger than an opening dimension of the through-hole in the predetermined direction at the first surface.

29. The method according to any one of claims 22 to 24, wherein the mask substrate includes a substrate body that defines the substrate opening,
wherein the mask intermediate layer includes a body region portion that is located between the mask body layer and the substrate body and an opening region portion that is located in the substrate opening in a plan view, and
wherein at the through-hole formation step, the through-hole is formed so as to extend through the mask body layer and the opening region portion.

30. The method according to claim 29, wherein an opening dimension of the through-hole in a predetermined direction at the second surface is larger than an opening dimension of the through-hole in the predetermined direction at the first surface.

31. The method according to any one of claims 22 to 24, wherein the resin material of the mask body layer contains polyimide.

32. The method according to any one of claims 22 to 24, wherein at the substrate opening formation step, a mask protection layer is provided on a surface of the mask layer opposite the mask substrate.

33. The method according to claim 32, further comprising:
a mask protection layer formation step of forming the mask protection layer on the surface of the mask layer opposite the mask substrate before the substrate opening formation step after the mask layer formation step, and
a mask protection layer removal step of removing the mask protection layer before the through-hole formation step after the substrate opening formation step.

34. The method according to any one of claims 22 to 24, wherein a thickness of the mask intermediate layer is less than a thickness of the mask body layer.

35. The method according to any one of claims 22 to 24, wherein the substrate opening formation step includes a resist layer formation step of forming a resist layer that includes a resist opening on a surface of the mask substrate opposite the mask layer and a substrate etching step of forming the substrate opening by etching the mask substrate through the resist opening.

36. The method according to claim 35, wherein the mask intermediate layer contains a material that is capable of ensuring adhesion to the mask substrate and that has resistance against an etching medium that is used at the substrate etching step.

37. The method according to claim 36, wherein the mask intermediate layer is in contact with the mask body layer and is in contact with the mask substrate.

38. The method according to any one of claims 22 to 24, wherein at the mask layer formation step, the mask intermediate layer is formed by performing a sputtering process.

39. The method according to any one of claims 22 to 24, wherein at the mask layer formation step, the mask intermediate layer is formed by performing a vapor deposition process.

40. The method according to any one of claims 22 to 24, wherein the mask layer includes two or more of the through-holes, and
wherein the two or more of the through-holes are located in the substrate opening in a plan view.

41. The method according to claim 40, wherein the mask layer includes two or more through-hole groups that are formed by the two or more of the through-holes, and
wherein the two or more through-hole groups are located in the substrate opening in a plan view.

42. The method according to claim 40, wherein the mask substrate includes two or more of the substrate openings,
wherein the mask layer includes two or more through-hole groups that are formed by the two or more of the through-holes, and
wherein the two or more through-hole groups are located in the substrate opening in a plan view.

43. The method according to claim 40, wherein the mask substrate includes two or more of the substrate openings,
wherein the mask layer includes two or more through-hole groups that are formed by the two or more of the through-holes, and
wherein the two or more through-hole groups are located in each substrate opening in a plan view.

44. The method according to any one of claims 22 to 24, wherein the substrate opening has a rectangular shape in a plan view, and
wherein curved portions are provided at four corners of a contour of the substrate opening in a plan view.

45. The method according to any one of claims 22 to 24, further comprising: a step of forming a first alignment mark on a surface of the mask substrate opposite the mask layer.

46. The method according to claim 45, wherein the mask substrate includes a substrate body that defines the substrate opening and an inner projecting portion that projects inward from the substrate body in a plan view, and
wherein the first alignment mark is located on the inner projecting portion.

47. The method according to claim 45, further comprising: a step of forming a second alignment mark at a position nearer than the first alignment mark to the through-hole.

48. The method according to claim 47, wherein the mask layer includes two or more of the through-holes, two or more through-hole groups that are formed by the two or more of the through-holes and a mask sash bar that is provided between the through-hole groups adjacent to each other, and
wherein the second alignment mark is located on the mask sash bar.

49. The method according to claim 48, wherein the mask sash bar includes a first mask sash bar and a second mask sash bar that extend in respective directions perpendicular to each other in a plan view, and
wherein the second alignment mark is located at an intersecting portion at which the first mask sash bar and the second mask sash bar intersect with each other.

50. The method according to any one of claims 22 to 24, wherein an outer edge of the mask body layer is located inside an outer edge of the mask intermediate layer in a plan view.

51. The method according to any one of claims 22 to 24, wherein the mask body layer includes two or more body islands, and
wherein a groove that extends through the mask body layer is located between two of the body islands adjacent to each other.

52. A method of manufacturing an organic device, the method comprising:
a vapor deposition mask preparation step of preparing the vapor deposition mask by using the method according to any one of claims 22 to 24;
a close contact step of causing the first surface of the mask layer of the vapor deposition mask to come into close contact with a vapor deposition substrate; and
a vapor deposition step of forming a vapor deposition layer in a manner in which a vapor deposition material is deposited on the vapor deposition substrate via the through-hole of the vapor deposition mask.

53. A method of manufacturing a framed vapor deposition mask, the method comprising:
a vapor deposition mask preparation step of preparing the vapor deposition mask by using the method according to any one of claims 22 to 24; and
a frame attachment step of attaching a frame to the mask substrate of the vapor deposition mask.
